# EUROPEAN PATENT APPLICATION

(11) **EP 1 670 074 A2**
(43) Date of publication of application: **14.06.2006**
(21) Application number: 05025580.1
(22) Date of filing: 23.11.2005
(51) Int. Cl.: H01L 33/00, F21S 8/10

(54) **Light emitting diode headlamp**

(30) Priority: 08.12.2004 JP 2004355735
(71) Applicant: Sumitomo Electric Industries, Ltd., Osaka-shi, Osaka 541-0041 (JP)
(72) Inventor: Nagai, Youichi, Osaka-shi, Osaka (JP); Nakamura, Takao, Itami-shi, Hyogo (JP); Katayama, Koji, Itami-shi, Hyogo (JP)
(74) Representative: Grünecker, Kinkeldey, Stockmair & Schwanhäusser Anwaltssozietät

(57) **Abstract**

An automotive headlamp is equipped with a light source containing one or more light-emitting devices (LEDs) and a base member (a pedestal and rear case) for securing the light source to the automobile. The LED includes: a GaN substrate 1; a n-type AlₓGa₁₋ₓN layer 3 on a first main surface side of the GaN substrate 1; a p-type AlₓGa₁₋ₓN layer 5 positioned further away from the GaN substrate 1 compared to the n-type AlₓGa₁₋ₓN layer 3; and a multi-quantum well 4 positioned between the n-type AlₓGa₁₋ₓN layer 3 and the p-type AlₓGa₁₋ₓN layer 5. In this LED, the specific resistance of the GaN substrate 1 is no more than 0.5 Ω·cm, the p-type AlₓGa₁₋ₓN layer 5 side is down-mounted, and light is discharged from a second main surface 1a, which is the main surface of the GaN substrate 1 opposite from the first main surface.

## Description

### BACKGROUND OF THE INVENTION

### Field of the Invention

The present invention relates to a light-emitting device. More specifically, the present invention relates to an automotive light-emitting device equipped with a light source including a light-emitting device formed from a nitride semiconductor substrate. In the present invention, a light-emitting device may refer to a semiconductor element formed essentially from a nitride semiconductor substrate and a semiconductor layer laminated thereon, or it may refer solely to a device in which a semiconductor chip is installed in a mounting section and sealed in resin. Also, the term may be used to refer to both of these at the same time. Also, the semiconductor chip may be referred to simply as a "chip". Also, a substrate and an epitaxial layer formed thereon in a chip may be referred to simply as a "substrate".

### Description of the Background Art

Currently, white light-emitting diodes (LED) are frequently used for illumination and compact electronic devices such as portable information terminals. However, there is the potential that they may be used for illumination in large spaces or over large areas in the future as well as in automotive headlamps (e.g., see Japanese Laid-Open Patent Publication Number 2003-260975). To make it possible to use LEDs for illumination of large spaces and large areas, the light output of LEDs must be increased. To do this, a high current must be applied to the electrodes of the LED and the problem of increased temperature resulting from heat generation must be resolved.

Fig. 61 shows the structure of a currently proposed GaN-based LED (Japanese Laid-Open Patent Publication Number 2003-8083). In this GaN-based LED, an n-type GaN layer 102 is disposed on a sapphire substrate 101, and a multi-quantum well 103 is formed between the n-type GaN layer 102 and the p-type GaN layer 104. Light emission takes place at the multi-quantum well 103. A p-electrode 105 is formed on the p-type GaN layer 104 to form an ohmic contact. Also, an n-electrode 106 is formed on the n-type GaN layer 102 to form an ohmic contact.

The p-electrode 105 and the n-electrode 106 are connected to a mounting part 109 through solder balls 107, 108. The mounting part 109 (sub-mount part) is formed from an Si substrate and is formed with a circuit for protecting the structure from external surge voltages. More specifically, in order to take into account the fact that surge voltages, e.g., transient voltages and static discharge, are the major factors in circuit malfunctions for group III nitride semiconductors such as Ga, Al, and In semiconductors, a power shunting circuit is formed from a zener diode and the like to protect the light-emitting device so that the light-emitting device does not receive high forward voltages and high reverse voltages. Protection from surge voltages will be described in detail later.

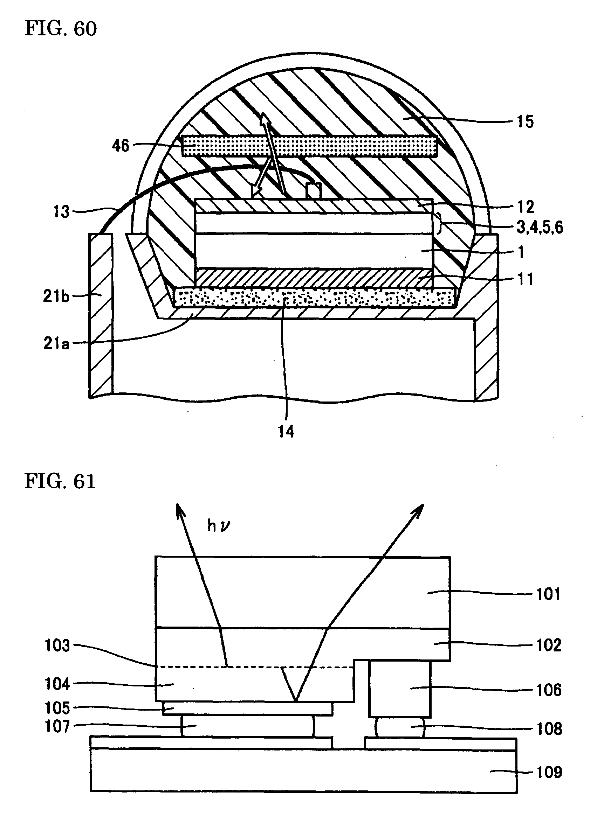

In this GaN-based LED, in order to emit light from the back surface side of the sapphire substrate 101: (a1) the p-type GaN layer 104 is down-mounted; and (a2) the n-electrode layer 106 is formed on the n-type GaN layer 102. As can be seen in Fig. 61, the structure of this GaN-based LED is very complex. The reason for having (a2) the n-electrode layer 106 on the n-type GaN layer 102, which results in this complexity, is that the n-type electrode cannot be formed on the sapphire substrate since the sapphire substrate 101 is an insulator.

Besides the light-emitting device that uses the sapphire substrate described above, there have been many other proposed technologies for GaAs-based, GaP-based, and GaN-based compound semiconductors used in light-emitting devices that also include a circuit to protect against transient voltages and static discharge (see Japanese Laid-Open Patent Publication Number 2000-286457, Japanese Laid-Open Patent Publication Number Hei 11-54801, Japanese Laid-Open Patent Publication Number Hei 11-220176). With GaN-based compound semiconductors especially, the reverse withstand voltage is low, at approximately 50 V, and the forward withstand is also only approximately 150 V. Thus, there has been an emphasis on providing a power shunting circuit for the protection described above. More specifically, the GaN-based chip or the like is formed on an Si substrate of a sub-mount, and a protection circuit containing a zener diode and the like is formed on the Si substrate. The many proposed protection circuits described above can be considered proof that surge voltages such as transient voltage and static discharge are the main factor in circuit malfunctions in group III nitride semiconductors such as Ga, Al, In semiconductors.

Apart from these light-emitting devices equipped with protection circuits, there are examples of GaN-based light-emitting devices formed on SiC substrates, which are conductors. More specifically, in one LED structure that is widely used, light is emitted from a p-type GaN layer using the following layered structure: (a back surface n-electrode on the SiC substrate / the SiC substrate / an n-type GaN layer / a quantum well structure (light-emitting layer) / a p-type GaN layer / a p-electrode).

The GaN-based LED using the sapphire substrate shown in Fig. 61 has a complex structure and will inevitably be costly to produce. In order to promote demand in applications such as automotive headlamps, the LEDs must be inexpensive, making this structure undesirable. Also, since the p-electrode 105 and the n-electrode 106 are disposed on the down-mounted side, restrictions are imposed on electrode area, especially the area of the p-electrode. In order to obtain high output with high current, it would be preferable for the p-electrode to be formed with an especially large area, but the restrictions imposed with the structure shown in Fig. 61 ultimately limits the light output. Furthermore, the arrangement of the two electrode layers on one side is also not desirable in terms of dissipating the heat generated by the current.

Also, current flowing in the direction parallel to the substrate of the n-type GaN layer 102 experiences high resistance, leading to heat generation as well as increased drive voltage requirements and power consumption. In particular, if the thickness of the n-type GaN layer is reduced to reduce the time required in the film-formation step, the n-type GaN film exposure yield is significantly reduced in addition to the problems described above regarding increased heat generation and power consumption.

While this can be said of light-emitting devices in general, including light-emitting devices that use sapphire substrates, the amount of current that can be applied to a single light-emitting device must be limited due to limited heat dissipation area and high heat resistance (the increase in temperature resulting from application of a unit energy per unit area). In particular, when a sapphire substrate is used, restrictions are imposed on the area of the p-electrode as described above, generally resulting in almost no leeway in thermal design.

Furthermore, since the heat dissipation area is limited in a GaN-based LED that uses a sapphire substrate, any attempt to reduce electrical resistance to lower heat generation leads to using a comb-shaped structure that interleaves p-electrodes and n-electrodes in order to increase contact area. The processing required for this type of comb-shaped structure is difficult and inevitably leads to higher production costs.

As described above, the design of heat conditions in light-emitting devices is of fundamental importance and restrictions are imposed by the conditions described above. Any attempt to relax these conditions leads to the use of complex electrode shapes.

Furthermore, there is also the following problem. Since the index of refraction of sapphire is approximately 1.8 and the index of refraction of GaN is approximately 2.4, when the GaN light-emitting device formed on the sapphire substrate is down-mounted and the back surface of the sapphire substrate is the light exit surface, total internal reflection takes place for light with an angle of incidence that is a predetermined value or more at the boundary surface between the GaN layer and the sapphire substrate, and this light is unable to exit.

More specifically, light for which the angle of incidence θ >= sin⁻¹ (1.8/2.4) = approximately 42 deg is stopped in the GaN layer and is unable to exit. As a result, light emission efficiency is reduced for the main surface of the sapphire substrate. While the issue of light emission efficiency is important, there are other problems. The light experiencing total internal reflection propagates through the GaN layer and exits from the sides of the GaN layer. Because the light experiencing total internal reflection is a fairly significant proportion, and also because the GaN layer is thin, the energy density of the light exiting from the sides is high. The sealing resin positioned at the sides of the GaN layer and exposed to the light is damaged, reducing the lifespan of the light-emitting device.

Also, with a GaN-based LED that emits light from the p-layer side with the structure (n-electrode on the back surface of an SiC substrate / SiC substrate / n-type GaN layer / multi-quantum well (light-emitting layer / p-type GaN layer / p-electrode), high-output light cannot be emitted out efficiently since the light absorption rate of the p-electrode is high. If the covering ratio of the p-electrode is reduced, i.e., the opening ratio is increased, to increase the light emission, the high electrical resistance of the p-type GaN layer prevents the flow of current throughout the entire p-type GaN layer. As a result, light emission for the entire multi-quantum well cannot be activated, and the light emission output is reduced. Also, the electrical resistance increases, resulting in heat generation and power supply capacity issues. Furthermore, if the p-type GaN layer is formed thicker in order to allow current to flow uniformly throughout the entire p-type GaN layer, the light absorption by the p-type GaN layer increases, limiting output.

The object of the present invention is to provide an automotive headlamp that uses a light-emitting device that is easy to make because it has a simple structure and that can provide high light emission efficiency in a stable manner over a long period of time.

### SUMMARY OF THE INVENTION

A headlamp according to the present invention is an automotive headlamp equipped with a light source containing one or more light-emitting devices and a base member for securing the light source to the automobile. The light-emitting device includes: a nitride semiconductor substrate; an n-type nitride semiconductor layer on a first main surface of the nitride semiconductor substrate; a p-type nitride semiconductor layer positioned further from the nitride semiconductor substrate than the n-type nitride semiconductor layer; and a light-emitting layer positioned between the n-type nitride semiconductor layer and the p-type nitride semiconductor layer. In this light-emitting device, the specific resistance of the nitride semiconductor substrate is no more than 0.5 Ω·cm, the p-type nitride semiconductor layer side is down-mounted, and light is discharged from a second main surface of the nitride semiconductor substrate, which is a main surface opposite from the first main surface.

In this structure, an n-type electrode is disposed on the back surface (the second main surface) of the nitride semiconductor substrate, which has a low electrical resistance. Thus, current can flow through the entire nitride semiconductor substrate even when the n-electrode is formed with a low covering ratio, i.e., a high opening ratio. As a result, the rate at which light is absorbed at the exit surface is reduced and light-emission efficiency is improved. As a result, adequate luminous flux can be obtained with one light-emitting device or a fewer number than would be required for a conventional device, making it possible to reduce the number of light-emitting devices required to obtain the luminous flux needed for a headlamp. Thus, the headlamp can be made at a relatively low cost. Of course, the discharge of light can take place not only from the second main surface but also from the side surfaces. This applies to the light-emitting devices described below as well.

Also, since the p-type nitride semiconductor layer side, which has a high electrical resistance, does not act as a light exit surface, the p-type electrode layer can be formed over the entire surface of the p-type nitride semiconductor layer, making it possible to use a design that is effective for dissipating generated heat when a high current is applied. In other words, restrictions imposed by heat-related factors are significantly relaxed. As a result, there is no need to use a comb-shaped structure that interleaves p-electrodes and n-electrodes to reduce electrical resistance.

Furthermore, the superior conductivity of the GaN substrate provides high-voltage resistance without requiring a special protection circuit for surge voltages.

Also, since complex processing is not required, production costs can be easily lowered.

The nitride semiconductor "substrate" refers to a plate-shaped object with enough thickness to allow independent carrying and is distinguished from "films" and "layers" that do not keep their own shapes independently during carrying. This applies to the GaN substrates and AIN substrates described below as well.

### BRIEF DESCRIPTION OF THE DRAWINGS

Fig. 1 is a simplified drawing showing an automobile equipped with an automotive headlamp according to the present invention.
Fig. 2 is a simplified cross-section drawing showing a headlamp mounted in the automobile shown in Fig. 1.
Fig. 3 is a drawing showing an LED according to an invention sample A of a first example of the present invention.
Fig. 4 is a drawing showing the layered structure including a light-emitting layer of the LED shown in Fig. 3.
Fig. 5 is a drawing showing the state of a wafer when a chip having the layered structure according to the invention sample A is taken from the wafer.
Fig. 6 is a drawing showing the arrangement of electrodes from Fig. 5.
Fig. 7 is a drawing showing a comparative sample B.
Fig. 8 is a drawing showing a layered structure including a light-emitting layer of the LED of the comparative sample B.
Fig. 9 shows the status of a wafer when a chip having the layered structure of the comparative sample B is taken from the wafer.
Fig. 10 is a drawing showing the arrangement of electrodes from Fig. 9.
Fig. 11 is a drawing showing the relationship between applied current and light output in the invention sample A and the comparative sample B.
Fig. 12 is a drawing showing the relationship between current density at a light-emitting layer and light output in the invention sample A and the comparative sample B.
Fig. 13 is a drawing showing an LED according to an invention sample C of a second example of the present invention.
Fig. 14 is a drawing showing an LED according to an invention sample C1 of a second example of the present invention.
Fig. 15 is a plan drawing of the LED of the invention sample C1 shown in Fig. 14.
Fig. 16 is a drawing showing the LED of a comparative sample E.
Fig. 17 is a plan drawing of the LED of the comparative sample E shown in Fig. 16.
Fig. 18 is a drawing showing the LED of an invention sample F according to a third example of the present invention.
Fig. 19 is a drawing showing the arrangement of electrodes when a chip with the layered structure of the invention sample F is taken from a wafer.
Fig. 20 shows a simplified drawing of the flow of current through an LED chip based on a simulation.
Fig. 21 is a drawing showing the current density ratio in a light-emitting layer of the LED of the third example of the present invention.
Fig. 22 is a drawing showing the relationship between light output and applied current in an LED (with no fluorescent material) according to the third example of the present invention.
Fig. 23 is a drawing showing the relationship between light output and current density at the light-emitting layer in an LED (with no fluorescent material) according to the third example of the present invention.
Fig. 24 is a drawing showing the relationship between light output and applied current in an LED (with fluorescent material: white) according to the third example of the present invention.
Fig. 25 is a drawing showing the relationship between light output and current density at a light-emitting layer of an LED (with fluorescent material: white) according to the third example of the present invention.
Fig. 26 is a drawing showing an alternative sample F-3 of an LED according to the third example of the present invention.
Fig. 27 is a plan drawing of the LED shown in Fig. 26.
Fig. 28 is a simplified drawing illustrating a transmittivity measurement test for an LED according to a fourth example of the present invention.
Fig. 29 is a drawing showing how light is transmitted through a substrate in the transmittivity measurement test shown in Fig. 28.
Fig. 30 is a drawing showing the influence of substrate thickness of transmittivity.
Fig. 31 is a drawing showing a wafer in a fifth example of the present invention after element separation etching has been performed to retrieve LEDs according to an invention sample L from the wafer.
Fig. 32 is a drawing showing a wafer in a fifth example of the present invention after element separation etching has been performed to retrieve LEDs according to an invention sample M from the wafer and n-electrodes are to be formed on the bottom of the etching grooves.
Fig. 33 is a drawing showing a wafer in a fifth example of the present invention after element separation etching has been performed to retrieve LEDs according to an invention sample N from the wafer and n-electrodes are to be formed on the bottom of the etching grooves.
Fig. 34 is a drawing showing an LED according to an invention sample Q according to a seventh example of the present invention.
Fig. 35 is a drawing showing an LED according to an invention sample R according to the seventh example of the present invention.
Fig. 36 is a drawing showing an LED according to an invention sample S and T according to an eighth example of the present invention.
Fig. 37 is a drawing showing an LED according to an invention sample U according to the eighth example of the present invention.
Fig. 38 is a drawing showing an LED according to an invention sample W according to the eighth example of the present invention.
Fig. 39 is a drawing showing the influence of oxygen concentration on the specific resistance of a GaN substrate in a ninth example of the present invention.
Fig. 40 is a drawing showing the influence of oxygen concentration on the transmittivity of light (450 nm wavelength) of a GaN substrate in the ninth example of the present invention.
Fig. 41 is a drawing showing the light output of light-emitting elements and plan sizes through which current flows uniformly when the light-emitting elements have been made from GaN substrates with different thicknesses and oxygen concentrations.
Fig. 42 is a drawing showing a core in a GaN substrate according to a tenth example of the present invention inherited by an epitaxial layer.
Fig. 43 is a drawing showing a core inherited by an epitaxial layer that has formed a hole-shaped indentation.
Fig. 44 is a drawing showing the distribution of off angles relative to the c-plane in a 20 mm × 20 mm GaN substrate in an eleventh example of the present invention.
Fig. 45 is a drawing showing the structure of the eleventh example of the present invention where a buffer layer is disposed between the GaN substrate and the AlGaN clad layer.
Fig. 46 is a drawing showing the results from when the off angle range within which a light output of at least 8 mW can be obtained was made wider in the eleventh example of the present invention.
Fig. 47 is a drawing showing a light-emitting element according to a twelfth example of the present invention.
Fig. 48 is a cross-section drawing that focuses on a p-electrode of a light-emitting element according to a thirteenth example of the present invention.
Fig. 49 is a plan drawing of the light-emitting element from Fig. 48 showing through to the p-electrodes.
Fig. 50 is a drawing showing light emission and reflection in an invention sample S5 according to the thirteenth example.
Fig. 51 is a drawing showing light emission and reflection in an comparative sample T6 according to the thirteenth example.
Fig. 52 is a drawing showing light emission and reflection in the invention sample A presented as a comparative sample for the thirteenth example.
Fig. 53 is a drawing showing a main surface of a GaN substrate on which plate-shaped inverted crystal domains appear in a grid pattern in a fourteenth example of the present invention.
Fig. 54 is a cross-section drawing of a GaN substrate showing the plate-shaped inverted crystal domains shown in Fig. 53.
Fig. 55 is a cross-section drawing showing an invention sample S6 of the fourteenth example of the present invention.
Fig. 56 is a plan drawing showing plate-shaped crystal domains from the fourteenth example of the present invention with a parallel arrangement different from that of Fig. 53.
Fig. 57 is a cross-section drawing of Fig. 56.
Fig. 58 is a cross-section drawing showing light emission and reflection in an invention sample S7 according to a fifteenth example of the present invention.
Fig. 59 is a cross-section drawing showing light emission and reflection in an invention sample S8, which is an alternate example of the fifteenth example of the present invention.
Fig. 60 is a cross-section drawing showing light emission and reflectivity in a comparative sample T7.
Fig. 61 is a drawing showing a conventional LED.

### DETAILED DESCRIPTION OF THE INVENTION

Next, using the figures, embodiments and examples of the present invention will be described. In the figures below, like or associated elements are assigned like numerals and their descriptions are not repeated.

### (First Embodiment)

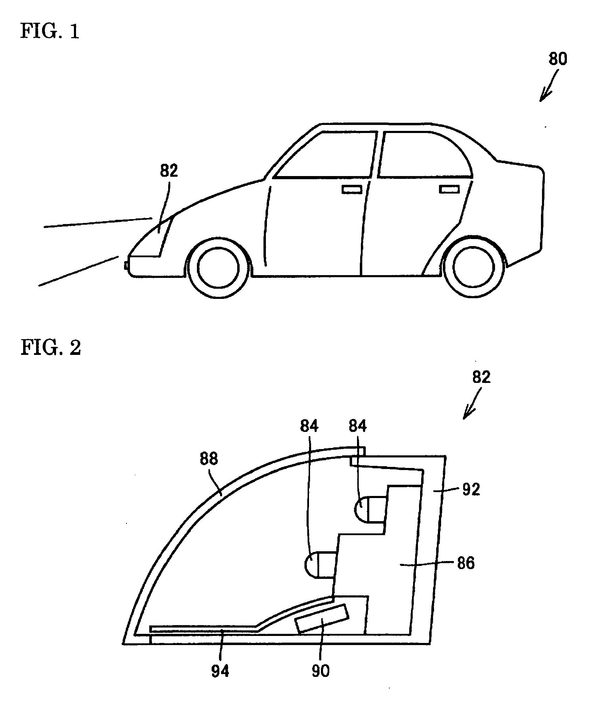

Fig. 1 is a simplified drawing showing an automobile equipped with an automotive headlamp according to the present invention. Fig. 2 is a simplified cross-section drawing showing the headlamp mounted on the automobile shown in Fig. 1. The headlamp according to the present invention will be described, with references to Fig. 1 and Fig. 2.

As shown in Fig. 1, a headlamp 82 as an embodiment of the present invention is placed on the front part of the body of an automobile 80. The headlamp 82 shines light in front of the automobile 80 in the direction of movement when the automobile 80 is running at night or inside a tunnel.

As shown in Fig. 2, the headlamp 82 is equipped with two LEDs 84 placed on top of a pedestal 86, a rear case 92 and a lens 88 which form a case for housing the pedestal 86, and inside the case, which is constructed from the rear case 92 and the lens 88, there is an internal reflective plate 94 which is placed below the LED 84 and a lighting circuit 90 which is placed underneath the internal reflective plate 94. The pedestal 86 can also function as a heat dissipating member for dissipating the heat generated from the LED 84 to the exterior of the headlamp 82. In addition, the number of LEDs 84 is not limited to two as indicated by the figure. There can be one or 3 or more. In addition, the LED 84 is attached to the vehicle via the pedestal 86 and the rear case 92, however, the LED 84 can be placed directly on the rear case 92. In this situation, the rear case 92 can function as a heat dissipating member by forming a heat dissipating plate on the rear case 92 or by connecting a cooling member or the like. In addition, a connecting part which directly connects the LED 84 with the automobile can be provided, and the LED 84 can be directly placed on this connecting part.

The LED 84 which is mounted on the headlamp 82 uses a nitride semiconductor substrate that is described below. The concrete structure of the LED 84 as a light-emitting device and its advantages are described in further detail below.

### (First Example)

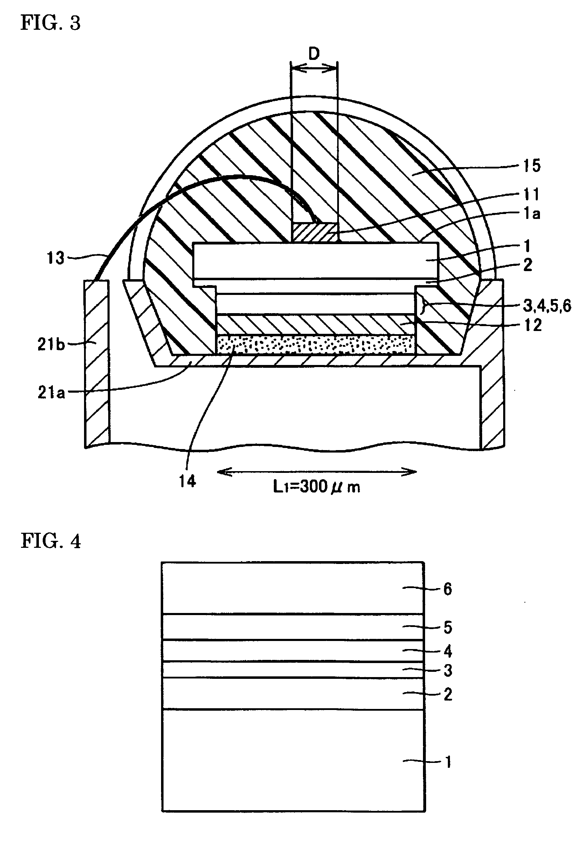

First, a GaN substrate, which is a nitride semiconductor substrate used in the LED 84 which serves as a light emitting device mounted on the headlamp 82 according to the present invention described above, will be compared with a sapphire substrate. Fig. 3 is a drawing showing the LED of an invention sample A which is used in the headlamp according to the first example of the present invention. A p-electrode 12 and a layered structure containing a light-emitting layer, which will be described in detail later, and the like are formed on a first main surface side of a GaN substrate 1. In this embodiment, the p-electrode 12 is down-mounted on a lead-frame mounting section 21a using a conductive adhesive 14.

A second main surface 1a of the GaN substrate 1 is a surface that emits light from the light-emitting layer, and an n-electrode 11 is disposed on this surface. The n-electrode 11 does not cover the entire second main surface. It is important that there is a high proportion that is not covered by the n-electrode 11. If the opening ratio is high, the light that is blocked due to the n-electrode 11 is reduced, and the emission efficiency of the light emitted outside is increased.

The n-electrode 11 is electrically connected to the lead 21b of the lead frame by a wire 13. The wire 13 and the layered structure described above are sealed with an epoxy-based resin 15. In the structure described above, Fig. 4 shows a detail of the layered structure from the GaN substrate 1 to the p-electrode 12. In Fig. 4, the layered structure shown in Fig. 3 is vertically inverted.

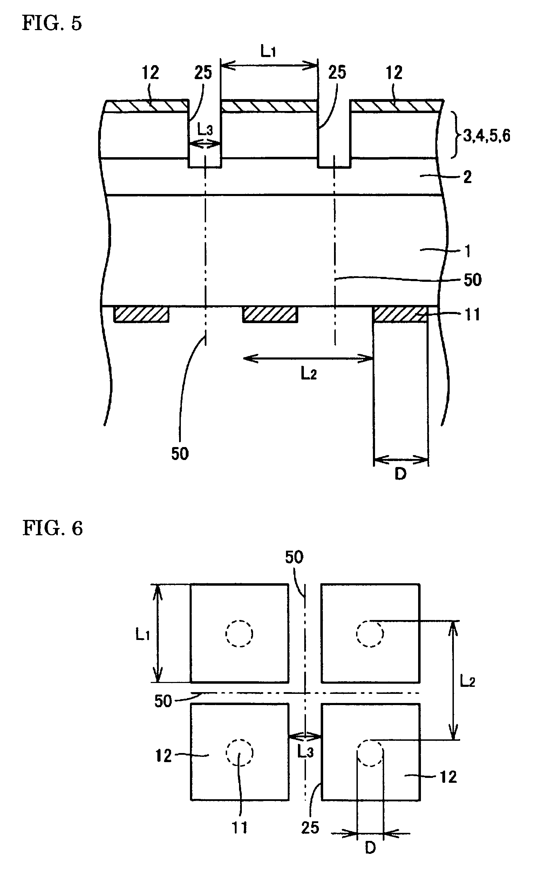

As shown in Fig. 4, an n-type GaN epitaxial layer 2 is formed on the GaN substrate 1, and an n-type AlₓGa₁₋ₓN layer 3 is formed thereon. On this is formed a multi-quantum well (MQW) 4 formed from an AlₓGa₁₋ₓN layer and an AlxInyGa1-x-yN layer. A p-type AlₓGa₁₋ₓN layer 5 is disposed so that the multi-quantum well 4 is interposed between it and the n-type AlₓGa₁₋ₓN layer 3. Also, a p-type GaN layer 6 is disposed on the p-type AlₓGa₁₋ₓN layer 5. In the structure described above, light is emitted at the multi-quantum well 4. Also, as shown in Fig. 3, the p-electrode 12 is formed and down-mounted on the p-type GaN layer 6 so that it covers the entire upper surface of the p-type GaN layer 6. Next, a method for making the LED of the invention sample A will be described.
(a1) A GaN off-substrate with a 0.5 deg offset from the c-plane was used.
   The specific resistance of the substrate was 0.01 Ω·cm. The dislocation density was 1E7/cm², and thickness was 400 microns. The specific resistance was obtained from the electrical resistance by the four-terminal method, and the dislocation density was obtained by observation with a TEM (transmission electron microscope). (The same for below.)
(a2) MOCVD (metal organic chemical vapor deposition) was used to form the layered structure on the Ga surface, which is the first main surface, of the GaN substrate: (Si-doped n-type GaN layer / Si-doped n-type Al_{0.2}Ga_{0.8}N layer being a clad layer / an MQW (multi-quantum well) formed by stacking three two-layer structures consisting of a GaN layer and an In_{0.15}Ga_{0.85}N layer / an Mg-doped p-type Al_{0.2}Ga_{0.8}N layer being a clad layer / an Mg-doped p-type GaN layer).
(a3) The light emission wavelength was 450 nm, and the internal quantum efficiency, which was calculated in a simplified manner by comparing the PL (photo luminescence) intensity at a low temperature of 4.2 K with the PL intensity at room temperature of 298K, was 50%.
(a4) The wafer was activated to reduce the resistance of the Mg-doped p-type layer. Carrier densities were determined by Hall measurement and was 5E17/cm³ for the Mg-doped p-type Al_{0.2}Ga_{0.8}N layer and 1E18/cm³ for the Mg-doped p-type GaN layer.
(a5) Photolithography and RIE (reactive ion etching) were performed on the wafer using a Cl-based gas to etch from the Mg-doped p-type layer side to the Si-doped n-type layer. As a result of this etching, element separation grooves 25 were formed as shown in Fig. 3, and the elements were separated. The width L3 of the element separation grooves was 100 microns.
(a6) Photolithography, vapor deposition, and lift-off were performed on the back N surface, which is the second main surface of the GaN substrate, to form n-electrodes having a diameter (D) of 100 microns at the center of the chips at a pitch of 400 microns (see Fig. 3 and Fig. 4). For the n-electrodes, a layered structure was formed in contact with the GaN substrate 1 with the following structure, starting from the bottom: (Ti layer 20 nm / A1 layer 100 nm / Ti layer 20 nm / Au layer 200 nm). This was heated in a nitrogen (N₂) atmosphere to obtain a contact resistance of no more than 1E-5 Ω·cm².
(a7) For the p-electrode, an Ni layer was formed in contact with the p-type GaN layer with a thickness of 4 nm, and on top of this an Au layer was formed over the entire surface with a thickness of 4 nm. (See Fig. 5 and Fig. 6). This was heated in an inert gas atmosphere to obtain a contact resistance of 5E-4 Ω·cm².
(a8) Then, as shown in Fig. 5 and Fig. 6, scribing was performed so that the chip boundaries 50 appeared as side surfaces, and the resulting chips formed light-emitting devices. In the light-emitting device chips, the light emission surface was 300 micron□ (a square with 300 micron sides), and the light-emitting layer was 300 micron□. More specifically, in Fig. 6, L1 = 300 microns, and L2 = 400 microns. Also, the element separation groove width L3 = 100 microns, and the diameter D of the n-electrode = 100 microns.
(a9) Referring to Fig. 3, the chip was mounted so that the p-type GaN layer side of the chip comes into contact with the lead frame mounting section 21a, resulting in the light-emitting device. The conductive adhesive 14 applied to the mounting section secures the light-emitting device and the mount and provides continuity.
(a10) In order to provide good dissipation of heat from the light-emitting device, the chip was mounted so that the entire surface of the p-type GaN layer of the light-emitting device comes into contact with the mounting section. Also, an Ag-based material, which has good heat conductivity, was used for the adhesive, and a CuW-based material, which has good heat conductivity, was used for the lead frame. As a result, the obtained heat resistance was 8 deg C/W.
(a11) Furthermore, the n-electrode and the lead section of the lead frame were connected using wire bonding, and an epoxy-based resin was used to seal the structure so that the light-emitting device formed a lamp.

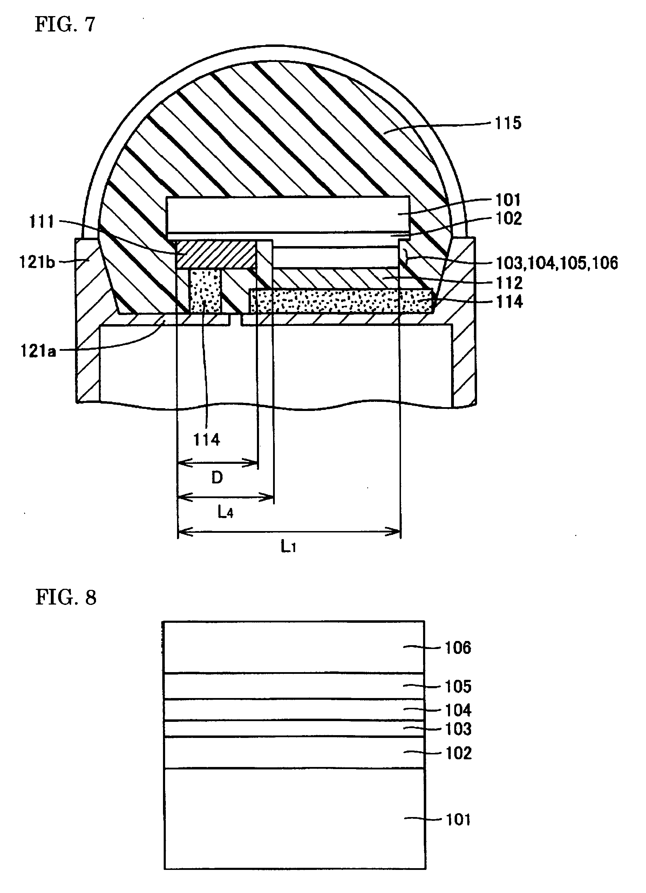

Next, a comparative sample B will be briefly described. In Fig. 7, a p-electrode 112 is down-mounted on a lead frame mounting section by a conductive adhesive 114. Furthermore, the n-electrode is connected by conductive adhesive 114 to a lead frame mounting section 121a separated from the lead mounting section to which the p-electrode is connected. A layered structure (Fig. 8) including a light emitting layer is formed thereon and is contacted with a predetermined area of an n-type GaN layer 102. The n-type GaN layer 102 is formed on a sapphire substrate 101, and an n-electrode 111 is formed on the area outside of the area with which the aforementioned layered structure is contacted. The n-electrode 111 is electrically connected to a lead frame mounting section 121a or a lead frame lead section 121b through a wire or conductive adhesive.

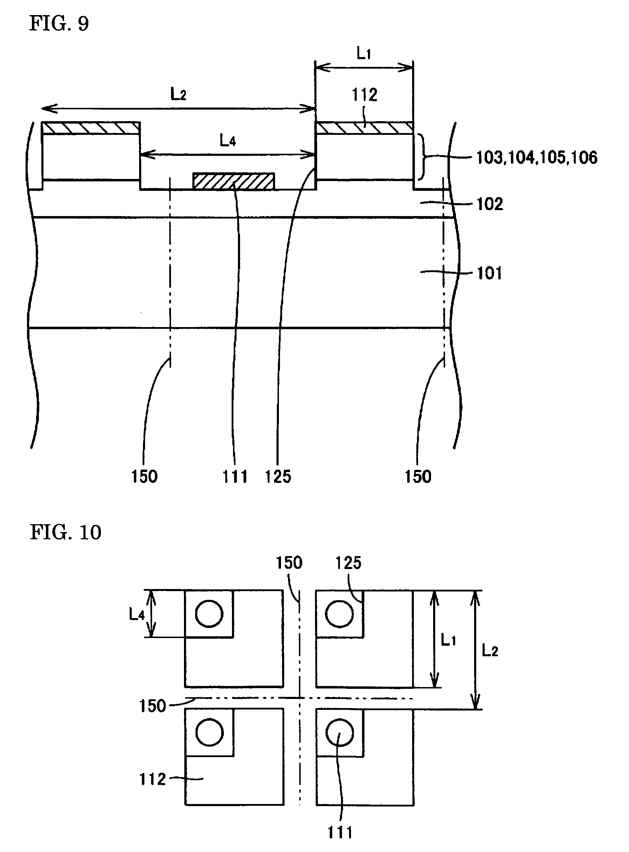

Light emitted from the light emitting layer is emitted outside through the sapphire substrate 101. An epoxy-based resin 115 is used to seal the aforementioned layered structure including the sapphire substrate. Next, a method for making the comparative sample B will be described.
(b1) A sapphire insulating off-substrate with a 0.2 deg offset from the c-plane was used. The sapphire substrate had a thickness of 400 microns.
(b2) - (b4) Operations identical to (a2) - (a4) from the invention sample A were applied to the sapphire substrate.
(b5) In the case of the comparative sample B, the sapphire substrate is an insulator, and therefore the n-electrode must be formed on the grown-films side, similarly to the p-electrode. Therefore, this wafer was etched from the Mg-doped p-type layer side to the Si-doped n-type layer using Cl-based gas by photolithography and RIE to expose the n-type GaN layer for forming the n-electrode. Then, the same element separation as that of the invention sample A was performed (Fig. 9 and Fig. 10). The shape of the element was a 300 micron□, and the exposed area of the n-type GaN layer therein was a 150 micron□ per element. More specifically, the square step of the exposed area had a side length L4 of 150 microns.
(b6) On the exposed n-type GaN layer, an n-electrode with a diameter of 100 microns was formed by photolithography, vapor deposition, and lift-off method. The thickness, the heat treatment, and the contact resistance were the same as those of the invention sample A.
(b7) A p-electrode was formed on the p-type GaN layer, i.e., the 300 micron□ element with the 150 micron□ n-type GaN exposed area removed. The thickness, the heat treatment, and the contact resistance were the same as those of the invention sample A.
(b8) - (b9) Operations identical to the corresponding steps from the invention sample A were performed.
(b10) As in the invention sample A, in order to facilitate the heat dissipation from the light-emitting device, the light-emitting device was mounted on the mount such that the entire surface of the p-type GaN layer of the light-emitting device was in contact therewith. In Fig. 7, the contact area between the p-type GaN layer 106 and the p-electrode 112 was set to 0.0675 mm². The heat generation of the light-emitting device occurs in the quantum well layer 104 and the p-type GaN layer 106 and therefore this heat dissipation is mainly determined by the area of the p-electrode 112. In the case of Fig. 7, the n-electrode 111 is also connected to the mounting section 121a of the lead frame by the conductive adhesive 114, but the heat dissipation area is substantially the aforementioned contact area 0.0675 mm². In the invention sample A, the contact area between the p-type GaN layer 6 and p-electrode 12 was 0.09 mm². The adhesive and the material of the lead frame were the same as those of the invention sample A. In the comparative sample B, in reflecting the aforementioned structure, the heat resistance was 10.4 deg C/W, which was greater than that of the invention sample A by a factor of 1.3, and therefore was degraded.
(b11) An operation identical to the corresponding step from the invention sample A was performed.

### (Tests and Results)

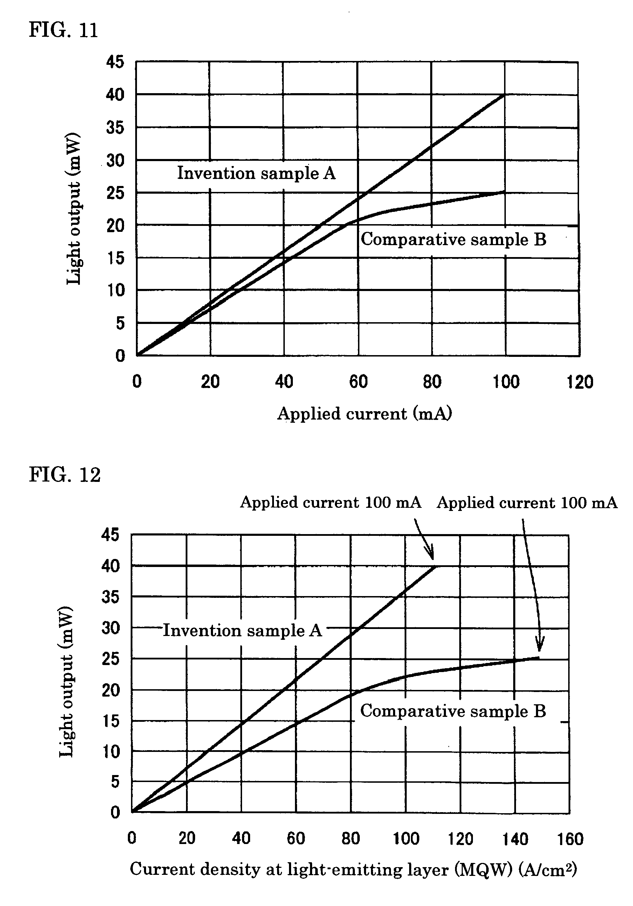

The invention sample A and the comparative sample B were mounted within an integrating sphere and then predetermined currents were applied to them. The values of output lights which were focused and output from a detector were compared. The result is shown in Fig. 11. In Fig. 11, under relatively ideal conditions where currents are applied into the MQW layer without leaking and there are relatively little non-radiation recombination in the MQW layer and low chip-temperature rise due to heat generation, the light output value increases in proportion to the increase of the applied current. For example, for application of 20 mA, the invention sample A generated an output of 8 mW, while the comparative sample B generated an output of 7.2 mW.

The invention sample A was mainly constructed by a GaN-based epitaxial film/GaN substrate, while the comparative sample B was mainly constructed by a GaN-based epitaxial film/sapphire substrate. The sapphire substrate had a index of refraction of about 1.8, and this was significantly smaller than the index of refraction of 2.4 for GaN. Therefore, in the comparative sample B, light was generated in the GaN-based epitaxial film and propagated, and than the light was prone to total internal reflection at the interface between the GaN-based epitaxial film and the sapphire substrate. For this reason, the output of the comparative sample B was lower than that of the invention sample A.

However, when the current was increased five-fold and 100 mA was applied to the invention sample A and the comparative sample B, the invention sample A generated five times the output, or 40 mA, while the comparative sample B generated only 25.2 mW (see Fig. 11). At this time, the current density in the MQW light-emitting area was 110 A/cm² in the invention sample A and 150 A/cm² in the comparative sample B as shown in Fig. 12. More specifically, the current density in the MQW light-emitting area of the invention sample A was larger than that of the comparative sample B.

This means that in the invention sample A the heat dissipating area was sufficiently large for the generated heat and the n-electrode was provided on the second main surface side of the substrate so that there was no area in which the current density became significantly large. On the other hand, in the comparative sample B the heat dissipating area was smaller than that of the invention sample A, and furthermore, the n-electrode was formed on the exposed n-type GaN layer, and therefore the current density of the current flowing through the n-type GaN layer in the direction parallel to the layer significantly increased. As a result, in the comparative sample B, heat generation further increased.

Furthermore, in the invention sample A, unlike in the comparative sample B, the n-electrode and the p-electrode are placed at opposite positions, and therefore there is no possibility of electrical short-circuits. Therefore, it is possible to prevent increases in additional fabrication cost such as for providing a film for electrically insulating between the p-electrode and n-electrode for preventing electrical short-circuits in the comparative sample B in which the electrodes exist at the same side.

Furthermore, test results about the electrostatic withstand voltages of the invention sample A and the comparative sample B will be described. The tests were performed by generating electric discharge between the light-emitting device and an electrostatically charged condenser. At this time, the comparative sample B was destroyed at an electrostatic voltage of about 100 V. On the other hand, the invention sample A was not destroyed until about 8000 V. It was found that the invention sample A had an electrostatic withstand voltage which was approximately 80 times that of the comparative sample B.

Furthermore, in the invention sample A, the GaN-based light-emitting device is formed on the GaN substrate. Therefore, even though the GaN-based light-emitting chip is down-mounted so that light is emitted from the back side of the GaN substrate, there is no difference in their indices of refraction. Thus, light propagates from the GaN-based light- emitting chip to the GaN substrate without experiencing total internal reflection. Therefore, as compared with structures in which a sapphire substrate is employed to form a GaN-based light-emitting device, the light output from the GaN substrate main surface may be increased. Furthermore, there will be no extremely-concentrated light emission from the sides of the GaN layer, and therefore the sealing resin will not be subjected to damage. Thus, the lifespan will not be restricted by the sealing resin.

As the invention sample, there has been merely described an example of the light emission wavelength of 450 nm, and the same effects may be obtained by different light emission wavelengths and layer structures. Of course, equivalent effects may be obtained by employing an AlₓGa₁₋ₓN substrate (wherein x is greater than 0 and is equal to or less than 1) instead of the GaN substrate, provided that the substrate has equivalent characteristics.

### (Second example)

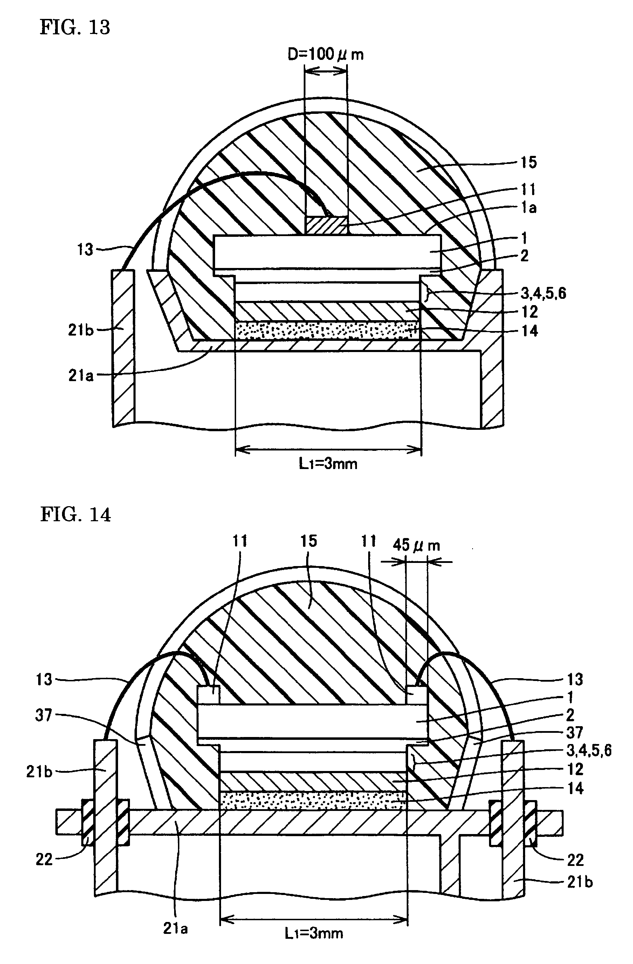

In a second example of the present invention, an invention sample C having an increased area will be described. The invention sample C has the same structure as that of the invention sample A shown in Fig. 3. However, while the dimension L1 is 0.3 mm (300 microns) in the invention sample A, L1 is increased ten-fold to 3 mm, and therefore the area is increased 100-fold in the invention sample C, as shown in Fig. 13. First, the method for making the invention sample C is as follows.

### (Invention sample C)

(c1) - (c5) Operations identical to the corresponding steps from the invention sample A were performed, but a larger GaN substrate was employed.
(c6) On the second main surface at the back side of the GaN substrate, n-electrodes with a diameter of 100 microns are formed with a pitch of 3.1 mm by a photolithography, vapor deposition and lift-off method. As the n electrodes, a layered structure, from the bottom side, of (a Ti layer 20 nm/an Al layer 100 nm/a Ti layer 20 nm/an Au layer 200 nm) was formed in contact with the back side of the above GaN substrate. This was heated in an inert atmosphere to reduce the contact resistance to below 1E-5 Ω·cm².
(c7) An operation identical to the corresponding steps from the invention sample A was performed.
(c8) Then, scribing was performed to form predetermined shapes, the resulting chips serving as the light-emitting devices. The light-emitting devices were 3 mm□.
(c9) - (c11) Operations identical to the corresponding steps from the invention sample A were performed. Then, an alternative sample C1 in which the placement of the n-electrode is changed from that of the invention sample C was made as follows.

### (Invention sample C1)

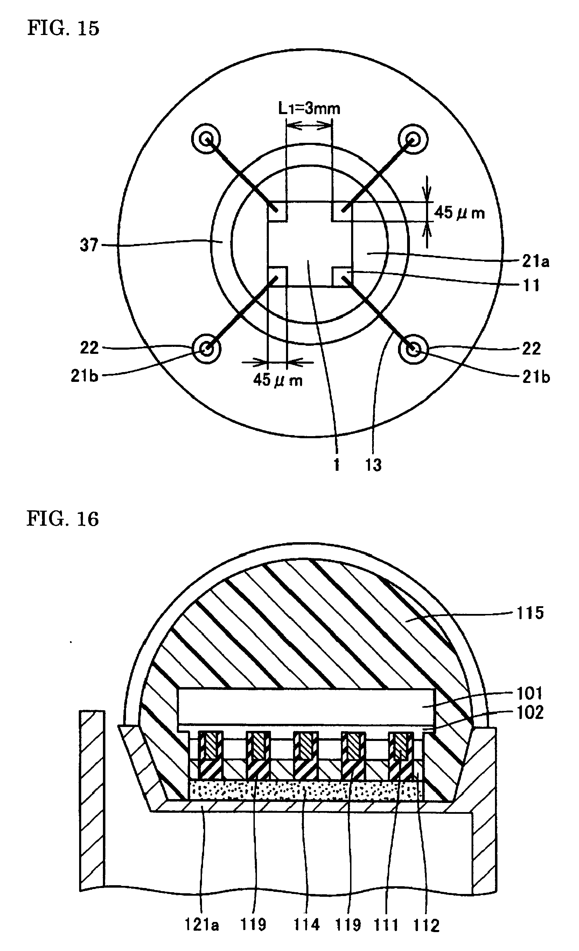

Fig. 14 and Fig. 15 are drawings showing the invention sample C1 which is an alternative example of the invention sample C. The invention sample C1 is characterized in that n-electrodes 11 are placed at the four corners of the GaN substrate. Furthermore, for mounting the semiconductor chip, a reflective cup 37 is placed in the lead frame such that it surrounds the semiconductor chip.

In making the invention sample C1, operations identical to the corresponding steps from the invention sample A were performed. However, four Au wires were employed as the bonding wires, and the diameter of the cross sections of the Au wires was 25 microns. Each of the n-electrodes placed at the four corners has a shape of a 45 micron□.

Next, the comparative sample D will be described. The comparative sample D has the same structure as that shown in Fig. 7. However, L1 was 300 microns (0.3 mm) in the comparative sample B, but L1 is increased ten-fold to 3 mm in the comparative sample D. The size L4 of the portion of the n-type GaN layer for forming an n-electrode is 150 microns, which is the same as that of the comparative sample B of Fig. 7. The method for making the comparative sample D is as follows.

### (Comparative sample D)

(d1) A larger insulating sapphire off-substrate with a 0.2.deg. offset from the c-plane was used. This substrate had a thickness of 400 microns.
(d2) - (d4) Operations identical to the corresponding steps from the invention sample A were performed.
(d5) In the comparative sample D, the sapphire substrate is an insulator and therefore the n electrode must be formed on the grown-films side similarly to the p-electrode. Photolithography and RIE were performed on the wafer using a Cl-based gas to etch from the Mg-doped p-type layer side to the Si-doped n-type layer to expose the n-type GaN layer for forming the n-electrode. Then, the same element separation as that in the invention sample A of was performed. The element had a size of a 3 mm□ and thus had a larger size. The size of the exposed area of the n-type GaN layer was a 150 micron□ per element.
(d6) On the exposed n-type GaN layer, n-type electrodes with a diameter of 100 microns were formed by photolithography, vapor deposition and lift-off method. The thickness, the heat treatment and the contact resistance were the same as those of the invention sample A.
(d7) P-electrodes were placed on the p-type GaN layer in which element separation grooves and the exposed areas of 150 micron□ of the n-type GaN layer for placing n-electrode had been removed from the element area of 3.1 mm□. The thickness, the heat treatment and the contact resistance were the same as those of the invention sample A.
(d8) - (d11) Operations identical to the corresponding steps from the invention sample A were performed.

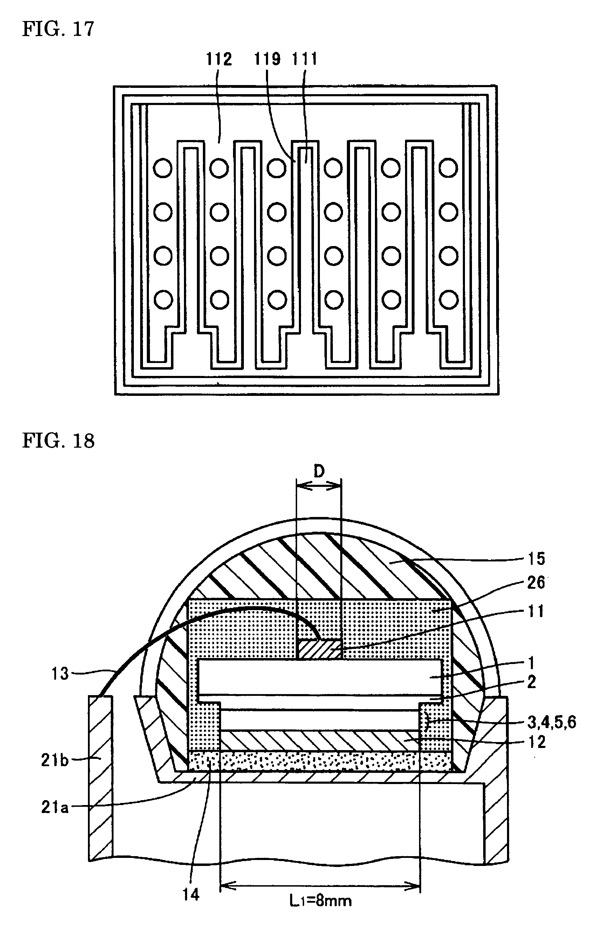

Next, another comparative sample E will be described. The comparative sample E is the same as the comparative samples B and D in that a sapphire substrate is employed and p-electrode 112 and n-electrode 111 are both formed on the down-mounted side as shown in Fig. 16. The comparative sample E is, however, different from them in that as clearly shown in the plan view in Fig. 17, p-electrode 112 has a comb-shape, n-electrodes 111 are placed between the teeth of the comb, and an insulator is placed between p-electrode 112 and n-electrodes 111. This is intended for making the current flowing through the p-electrode and the n-electrode uniform in order to prevent formation of areas in which the current density becomes extremely large. The method of making this comparative sample E is as follows.

### (Comparative sample E)

With the same method for making the comparative sample D, as the n-electrodes 111, five comb electrodes with a width of 0.1 mm were formed with a pitch of 0.5 mm (Fig. 16 and Fig. 17). The p-electrode was formed at the remaining back area of the n-type GaN layer 102 such that the n-electrodes 111 and the p-electrode 112 were spaced by 0.1 mm from each other. Furthermore, an insulator 119 for surface protection was formed in the space between the n-electrodes and the p-electrode in order to prevent the respective electrodes from being electrically short-circuited. Furthermore, in order to prevent short-circuits, a conductive adhesive 114 was provided on the area of the mounting section 121a of the lead frame which corresponded to the position of the respective electrodes. The chip was mounted to the lead frame while displacement of the chip and the lead frame in the lateral direction, the longitudinal direction and the rotation direction were controlled.

### (Tests and Results)

The invention sample C and the comparative sample D were mounted within an integrating sphere and then predetermined currents were applied to them. The values of output lights which were focused and output from a detector were compared. For example, when a current of 20 mA was applied, the invention sample C generated an output of 8 mW, while the comparative sample D generated an output of 7.2 mW. On the other hand, when a current of 2 A (2000 mA) was applied, the invention sample C generated 100 times the output, i.e., 800 mW. However, the comparative sample D was destroyed.

Therefore, under the condition where the comparative sample D was not sealed with resin, electric currents were applied to the comparative sample D and the temperature of the element was measured by a thermoviewer. As a result, it was found that abnormal heat generation occurred at the area in which currents intensively flowed through the n-type GaN layer in the direction parallel to the layer from the n-electrode toward the MQW light-emitting portion, and consequently the comparative sample D was destroyed.

Thus, in contrast to the comparative sample D, there was fabricated a light-emitting device having a structure in which currents flowing through the n-type GaN layer in the direction parallel to the layer from the n-type electrode toward the MQW light- emitting portion were distributed. This was the comparative sample E. The comparative sample E generated an output of 7.2 mW for an applied current of 20 mA, and an output of 720 mW for an applied current of 2 A. Thus, the comparative sample E generated outputs which were 0.9 times that of the invention sample C.

Thus, in order to obtain a performance near that of the invention sample C, significantly complicated structures and processes are required as compared with the invention sample C, and therefore the costs increase.

Then, for the invention sample C and the comparative samples D and E, electrostatic withstand voltage tests were performed. The tests were performed, as previously described, by generating electric discharge between the light-emitting device and an electrostatically charged condenser. Then, the comparative samples D and E were destroyed at an electrostatic voltage of 100 V. On the other hand, the invention sample C was not destroyed until about 8000 V. More specifically, the invention sample offered a significantly high electrostatic withstand voltage, which was approximately 80 times that of the comparative samples.

The invention sample C1 had an opening ratio much greater than 50% and almost 100%. Furthermore, since n-electrodes 11 are placed at the corners of the GaN substrate, they are much less prone to become obstructions of light extraction, as compared with the case where they are placed at the center. As shown in Fig. 14, in a plan view, the n electrodes 11 are placed outside of the light-emitting layer, and thus, the n electrodes 11 will never affect the light extraction. As a result, the invention sample C1 can achieve higher outputs than the invention sample C.

### (Third example)

In a third example of the present invention, the influence of the opening ratio at the light-emitting surface and the electrical resistance of the GaN substrate on the light output were determined. The adjustment of the opening ratio was performed by varying the substrate area, the p-electrode size and the n-electrode size. As a test sample, an LED having the structure shown in Fig. 3 was used. However, some of the tests were performed for a test sample provided with a fluorescent material 26 to be formed as a white LED as shown in Fig. 18. The test samples were three samples, namely the invention sample F and the comparative samples G, H in which each includes a GaN substrate having a specific resistance deviating from the range of the present invention. For each sample F, G and H, an LED including no fluorescent material and sealed with epoxy-based resin as shown in Fig. 1 and a white LED equipped with a fluorescent material as shown in Fig. 18 were created. The opening ratio was defined as follows: {(area of p-electrode-area of n-electrode)/area of p-electrode} × 100(%).

In the invention sample F, L1=8 mm, D=100 microns, and the opening ratio is almost 100%. Also, in the comparative sample G, L1=0.49 mm, D=100 microns and the opening ratio is 97%. In the comparative sample H, L1=8 mm, D=7.51 mm and the opening ratio is 31%. The methods for making the aforementioned the invention sample F, the comparative samples G and H will be described.

### (Invention sample F)

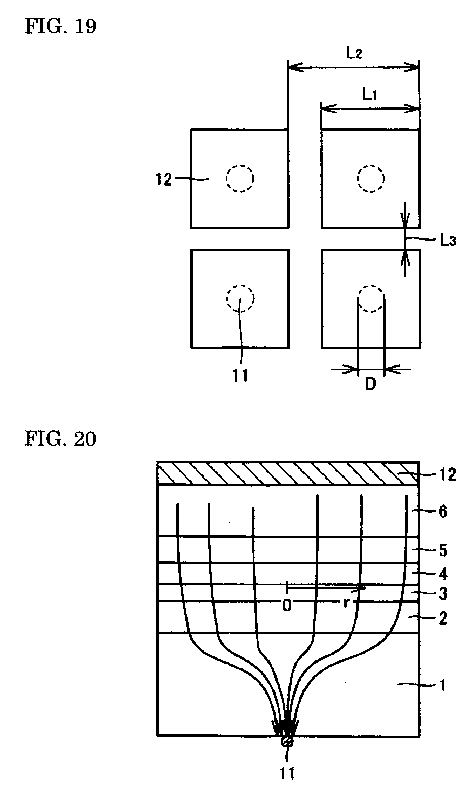

(f1) - (f5) Operations identical to the corresponding steps from the invention sample A were performed.
(f6) Then, as shown in Fig. 19, scribing was performed to form predetermined shapes, the resulting chips serving as the light-emitting devices. The light-emitting devices were 8 mm□.
(f7) - (f11) Operations identical to the corresponding steps from the invention sample A were performed.
(f12) In addition to the above (f11), a white-emitting lamp was made by mounting a fluorescent material on the n-electrode side of the light-emitting device which had been mounted on the mount of the lead frame in (f10) and then sealing the light-emitting device with an epoxy-based resin. For this, a fluorescent material which generated 180 1m for 1 watt of light output with 450 nm was used.

### (Comparative sample G)

(g1) An n-type GaN off-substrate with a 0.5 deg offset from the c-plane was used. A GaN off-substrate having a specific resistance of 0.6 Ω·cm, which was higher than the range of the present invention of 0.5 Ω·cm or less, was selected. The GaN substrate had a dislocation density of 1E7/cm² and a thickness of 400 microns.
(g2) - (g5) Operations identical to the corresponding steps from the invention sample F were performed.
(g6) Then, scribing was performed to form predetermined shapes, the resulting chips serving as the light-emitting devices. The light-emitting devices were 0.49 mm□.
(g7) - (g12) Operations identical to the corresponding steps from the invention sample F were performed.

### (Comparative sample H)

(h1) An n-type GaN off-substrate with a 0.5 deg offset from the c-plane was used. A GaN off-substrate having a specific resistance of 0.6 Ω·cm, which was higher than the range of the present invention of 0.5 Ω·cm or less, was selected. The GaN substrate had a dislocation density of 1E7/cm² and a thickness of 400 microns.
(h2) - (h5) Operations identical to the corresponding steps from the invention sample F were performed.
(h6) Then, scribing was performed to form predetermined shapes, the resulting chips serving as the light-emitting devices. The light-emitting devices were 8 mm□.
(h7) - (h12) Operations identical to the corresponding steps from the invention sample F were performed.

### (Tests and Results)

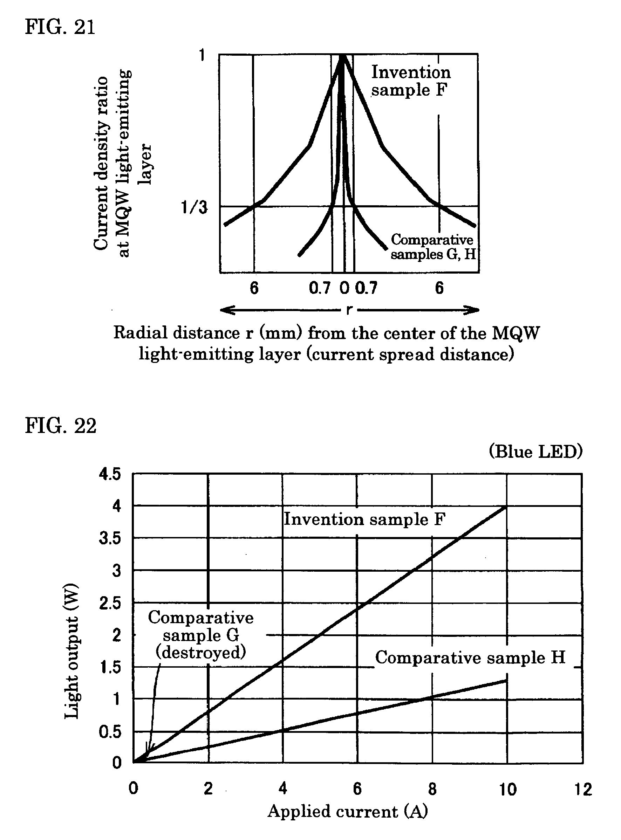

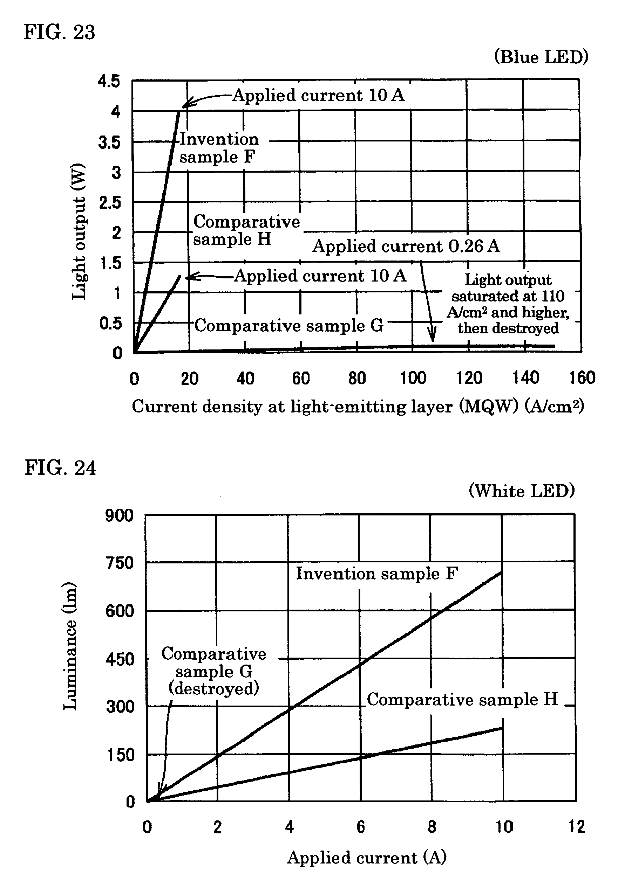

(1) For the invention sample F and the comparative samples G and H, the current distribution in the area in which currents spread relatively uniformly from the n-electrode toward the MQW layer was calculated by simulations. The results of the simulations are reflected on the element designs of the invention sample F and the comparative samples G and H. Fig. 20 shows a conceptual drawing of the spread of currents. Fig. 21 is a drawing showing the current density ratio at the distance r, wherein r is the radial distance from the center of the MQW light-emitting layer 4. The current density at the center of the n-electrode is defined as 1.
   (i) The result of the invention sample F: the current density was at a maximum directly under the n-electrode and decreased with increasing distance from the n-electrode. Also, the range in which the current density was at least 1/3 of that directly under the n-electrode was a range with a diameter of 12 mm centered directly under the n-electrode. Based on these results, the size of the light-emitting device was set to 8 mm□ which was included therein. On the N-surface, which was the second main surface of the GaN substrate, n-type electrodes with a diameter of 100 microns were formed at the centers of chips with a pitch of 8.1 mm by photolithography, vapor deposition and lift-off method. In this case, the ratio of the area of the N-surface of the GaN substrate at which no n-electrode existed, i.e., the opening ratio, was substantially 100% per element. The thickness, the heat treatment and the contact resistance were the same as those of the invention sample A.
   (ii) The result of the comparative sample G: the range in which the current density exceeded 1/3 of that directly under the n-electrode was a range with a diameter of 0.7 mm centered directly under the n-electrode. Thereupon the diameter of the n-electrode was set to 100 microns in agreement with the invention sample E, and the chip size was set to 0.49 mm□, which was included in the diameter of 0.7 mm. On the N-surface of the GaN substrate, n-type electrodes with a diameter of 100 microns were formed at the centers of chips with a pitch of 0.5 mm by photolithography, vapor deposition and lift-off method. In this case, the opening ratio was about 97% per element. The thickness, the heat treatment and the contact resistance were the same as those of the invention samples A - E.
   (iii) In the comparative sample H, the chip size was set to 8 mm□ in agreement with the invention sample E. The GaN substrate had the same electrical resistance as that of the comparative sample G, and the diameter of the spread of currents would be 0.7 mm. Therefore, in order to flow currents through the 8 mm□ uniformly (1/3 or more of the current density directly under the n-type electrode), the n-electrode was required to have a diameter of 7.51 mm. Thus, on the second main surface (light-emitting surface), n-electrodes with a diameter of 7.51 mm were formed with a pitch of 8.1 mm by photolithography, vapor deposition and lift-off method and the width of the scribing was set to 0.1 mm. In this case, the opening ratio was about 31% per element.
(2) The invention sample F and the comparative samples G and H equipped with no fluorescent material were mounted within an integrating sphere and then predetermined currents were applied to them. The values of output lights which were focused and then output from a detector were compared. The results are shown in Fig. 22 and Fig. 23.

When applying a current of 20 mA, the invention sample F and the comparative samples G and H generated outputs of 8 mW, 7.8 mW and 2.5 mW respectively, which were consistent with the area ratio of the area at which the electrode was not formed. The invention sample F generated the highest light output. The comparative sample G generated a light output which was not high as that of the invention sample F, but was relatively high. Then, when 500 times the current, or 10 A, was applied to them, the invention sample F and the comparative sample H generated outputs of 4 W and 1.3 W respectively, which were consistent with the area ratio in which the electrode was not formed.

The output of the comparative sample G increased in proportion to the applied current to 0.1 W at an applied current of 0.26 A and thus at a current density in the light emitting portion of 110 A/cm². However, from then on, the output reached saturation with increasing temperature caused by heat generation, and the comparative sample G was destroyed by an applied current of 10 A.

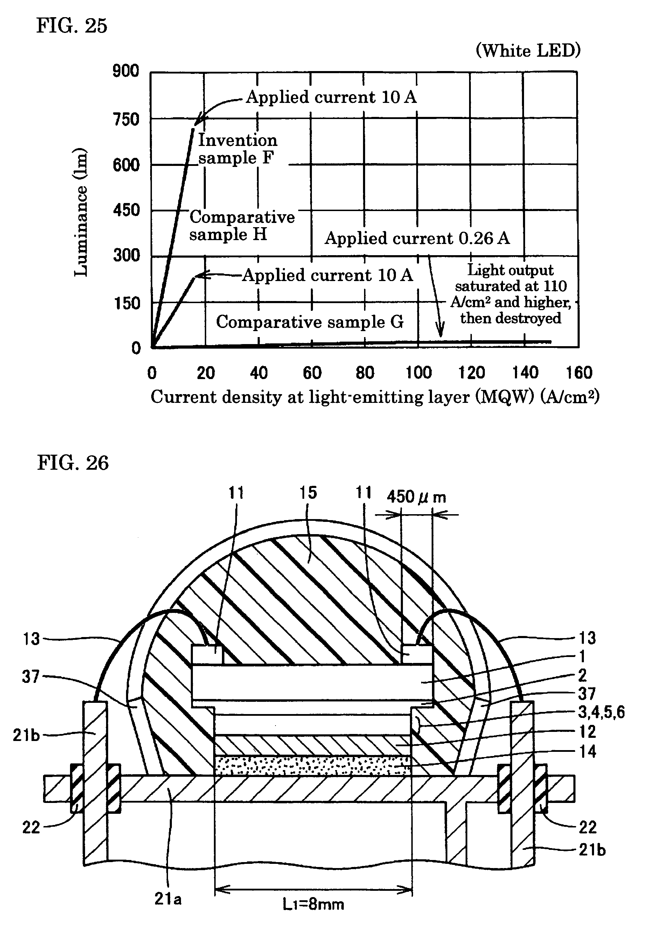

Fig. 24 and Fig. 25 show the results of luminance measurements for the aforementioned three types of test samples. Fig. 24 shows the relation between the applied current and the resultant luminance for the white-emitting LEDs equipped with a fluorescent material. Fig. 25 similarly shows the relation between the current and the luminance. The same fluorescent material was used in the invention sample F and the comparative sample H, but the luminance varied depending on the area ratio of the area at which the electrode was not placed. Thus, when the applied current was 10 A, the luminances of the invention sample F and the comparative sample H were 720 lm/chip and 234 lm/chip respectively. The comparative sample G had a thermal limit of 18 lm/chip at an applied current of 0.26 A and was destroyed by an applied current of 10 A. According to Fig. 24 and Fig. 25, only the invention sample F generated high luminances at high currents.

Furthermore, in the present embodiment, the applied current is 10 A at the maximum since if the current is increased above that, then the Joule heat density at the n-electrode will become excessive and consequently significant heat generation will occur.

By increasing the size of the n-electrode or by sufficiently reducing the contact resistance, the same effects may be achieved for currents up to a maximum current of 70 A, which corresponds to a current density of 110 A/cm².

### (Invention samples F-2 and F-3)

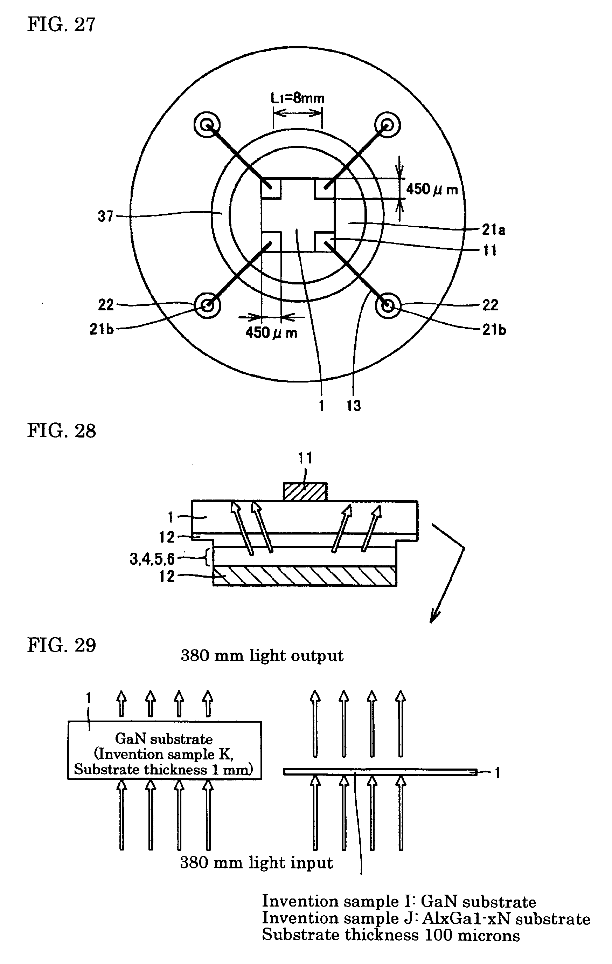

The same operations as the invention sample F were performed. In the invention sample F-2, the n-electrode was formed with the diameter D set to 1 mm (0.785 mm² area) and was positioned at the center of the GaN substrate. In the invention sample F-3, n-electrodes were formed 450 microns□ and positioned at the four corners of the GaN substrate (see Fig. 26 and Fig. 27). As shown in Fig. 26 and Fig. 27, the n-electrodes positioned at the four corners are each connected electrically to the lead frame through wire bonding. Au wire was used for the bonding wire, with a cross-section diameter of 300 microns. The opening ratio was roughly 100% for both cases. Also, as in the invention sample C1, the reflective cup 37, which is a cup-shaped reflecting body, was used.

The light-emitting device with no fluorescent material was mounted in an integrating sphere as in the invention sample F and current was applied to generate light. Light output values from a detector that focuses the light were measured, and a current of 20 mA resulted in an output of 8 mW, a current 500 times this, 10 A, resulted in an output of 4 W, and a current of 70 A resulted in an output of 28 W.

When a fluorescent material was used for a white-light LED, a luminance of 5040 1m/chip was obtained.

Of course, similar output could be obtained by arranging multiple small and relatively low-current light-emitting devices. However, this is not practical because: the elements would have to be separated from each other by a fixed distance due to element positioning precision and to avoid electrical short-circuits; the overall size would become extremely large; providing continuity to each individual element would result in extremely high cost; and the like. With the present invention, these problems can be avoided and a high light output can be obtained using exactly the same number of production processes as in the conventional technology at roughly the same cost while keeping size down to a minimum.

Of course, similar advantages can be provided even if emitted wavelength or the layer structure is changed or if the GaN substrate is replaced with an AlxGa1-x substrate (where x is greater than 0 and no more than 1) as long as the characteristics of the substrate are equivalent.

As shown in Fig. 26 and Fig. 27, the electrodes and wires are prevented from hindering light extraction by using four Au wires with 150 micron radius to connect the n-electrodes at the corners of the GaN substrate with the lead frame. This provides further improvements in light output.

### (Fourth example)

With regard to the fourth example of the present invention, the effect of the thickness of the GaN substrate on light output will be described. GaN substrate light absorption was measured for the three invention samples I, J, K having the same structure as the LED shown in Fig. 3. The method for making the samples will be described.

### (Invention sample I)

(i1) An n-type GaN off substrate with a 0.5 deg offset from the c-plane was used. The specific resistance of the GaN substrate was 0.01 Ω·cm, and the dislocation density was 1E7/cm². The thickness of the GaN substrate was 100 microns.
(i2) MOCVD was performed to form the following layers on the first main surface of the GaN substrate in order: (a GaN buffer layer / an Si-doped n-type GaN layer / an Si-doped n-type Al_{0.2}Ga_{0.8}N layer, being a clad layer / an MQW layer formed by stacking three two-layer structures consisting of a GaN layer and an In_{0.05}Ga_{0.95}N layer / an Mg-doped p-type Al_{0.2}Ga_{0.8}N layer, being a clad layer / an Mg-doped p-type GaN layer).
(i3) The wavelength of the emitted light was 380 nm, and the internal quantum efficiency was 50% when calculated in a simplified manner by comparing the PL intensity at a low temperature of 4.2 K with the PL intensity at a room temperature of 298 K.
(i4) - (i5) Operations identical to the corresponding operations from the invention sample A were performed.
(i6) First, a simulation was performed to calculate a range in which current would flow relatively uniformly from a point-shaped n-electrode to the MQW layer. The result showed that current density decreased as the distance from the n-electrode increased, with the current density being highest immediately below the n-electrode. Also, since the range in which the current density was at least 1/3 the value directly below the n-electrode was a diameter of 3 mm around the point directly below the n-electrode, so the size of the light-emitting device was set to 1.6 mm□, which would cover all of this. N-type electrodes with a diameter of 100 microns were formed on the N surface of the GaN substrate at 1.7 mm intervals using photolithography, vapor deposition, and lift-off. In this case, the sections of the Ga surface of the GaN substrate on which the n-type electrodes are not formed, i.e., the opening ratio, was roughly 100% for each element. Thickness, heat treatment, and contact resistance were the same as in the invention sample A.
(i7) Operations identical to the corresponding step from the invention sample A were performed.
(i8) Then, scribing was performed to form predetermined shapes, the resulting chips serving as the light-emitting devices. The light-emitting devices were 1.6 mm□.
(i9) - (i11) Operations identical to the corresponding steps from the invention sample A were performed.

### (Invention sample J)

(j1) An AlₓGa₁₋ₓN off-substrate offset from the c-plane by 0.5 deg was used. Specific resistance was 0.01 Ω·cm and dislocation density was 1E7/cm². The thickness of the n-type AlₓGa₁₋ₓN substrate was 100 microns. Three types were used having Al atom ratios x = 0.2, 0.5, 1.
(j2) MOCVD was performed to form the following layered structure on the first main surface of the AlₓGa₁₋ₓN substrate: (an Si-doped n-type clad Al_{0.2}Ga_{0.8}N layer, being a clad layer / an MQW layer formed by stacking three two-layer structures consisting of GaN and In_{0.05}Ga_{0.95}N / an Mg-doped p-type Al_{0.2}Ga_{0.8}N layer, being a clad layer / an Mg-doped p-type GaN layer).
(j3) - (j5) Operations identical to those from the corresponding steps from the invention sample I were performed.
(j6) N-electrodes having a diameter of 100 microns were formed at 400 micron intervals on the second main surface of the Ala-xGaxN substrate using photolithography, vapor deposition, and lift-off. The n-electrodes are formed in contact with the second main surface of the All-xGaxN substrate as the following layered structure, starting from the bottom: (Ti layer 20 nm / Al layer / 100 nm / Ti layer 20 nm / Au layer 200 nm). This was heated in an inert atmosphere, resulting in a contact resistance of no more than 1E-4 Ω·cm².
(j7) - (j11) Operations identical to those from the corresponding steps from the invention sample I were performed.

### (Comparative sample K)

(k1) An n-type GaN off-substrate with an 0.5 deg offset from the c-plane was used. The specific resistance of this GaN substrate was 0.01 Ω·cm and the dislocation density was 1E7/cm². The GaN substrate had a thickness of 1 mm (1000 microns).
(k2) - (k5) Operations identical to those from the corresponding steps from the invention sample I were performed.
(k6) The size of the light-emitting element (chip) was 1.6 mm□, the same as the invention sample G. N-electrodes having a diameter of 100 microns were formed on the second main surface of the GaN substrate at 1.7 mm intervals using photolithography, vapor deposition, and lift-off. In this case, the proportion of the sections of the second main surface (light exit surface) of the GaN substrate on which the n-electrodes were not formed, i.e., the opening ratio, was roughly 100% per element. The thickness, heat treatment, and contact resistance were the same as the invention sample I.
(k7) - (k11) Operations identical to those from the corresponding steps from the invention sample I were performed.

### (Tests and results)

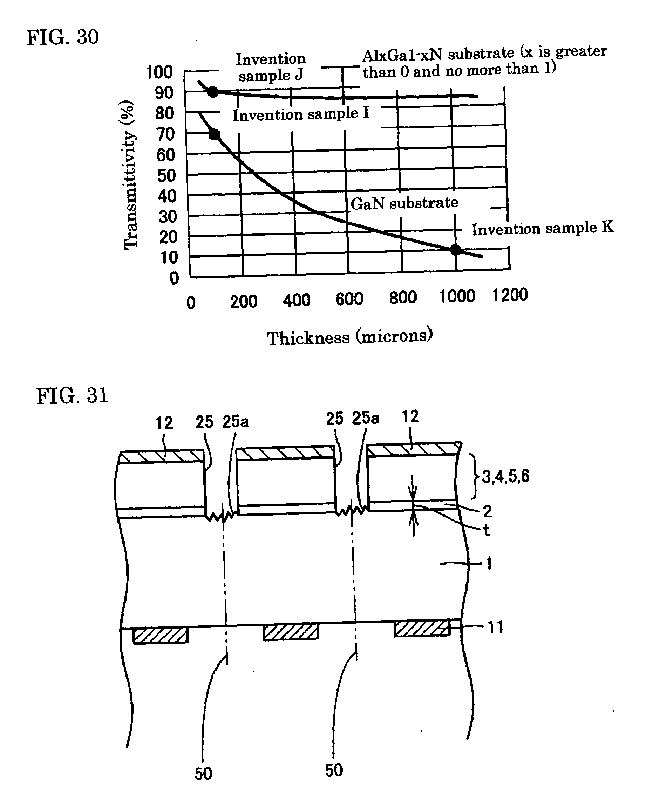

First, substrates 1 for the comparative sample K and the invention sample I, J with different substrate thicknesses were prepared and transmittivity was measured for incident light having a wavelength of 380 nm. Fig. 28 and Fig. 29 show simplified drawings of the transmittivity measurement tests. The thickness of the invention samples I and J were 100 microns, but the invention sample K was thicker, with a thickness of 1 mm (1000 microns). The results of the tests are organized in Fig. 30.

According to Fig. 30, the transmittance for the invention samples I, J and the comparative sample K were 70%, 90%, and 10% respectively. In the invention sample J, the Al atom ratios x were 0.2, 0.5, and 1, but the transmittivity was 90% for all of these.

The invention samples I, J and the comparative sample K, formed as white LEDs by installing fluorescent materials, were mounted in an integrating sphere and a predetermined current was applied. The light was focused and light output values from a detector were compared. When a current of 20 mA was applied, outputs of 4.2 mW, 5.4 mW (for all three types described above), and 0.6 mW were obtained for the invention samples I, J and the comparative sample K respectively. The differences result from the differences in transmittivity of the substrates. However, with a GaN substrate, light transmittance is dramatically lower for wavelengths shorter than 400 nm, so in such cases greater light extraction can be obtained with an AlₓGa₁₋ₓN as in the present invention.

Also, greater light extraction can be obtained by making the GaN substrate thinner. Since a substrate that is too thin will result in the spreading range of the current from the n-electrode to the MQW being too small while a substrate that is too thick will reduce extraction efficiency, it would be preferable for the thickness to be 50 microns - 500 microns. Also, by using a thin GaN substrate with a thickness of approximately 100 microns as in the invention sample, the production cost of the GaN substrate can be reduced, making it possible to make a low-cost light-emitting device. Of course, cost can be reduced regardless of the wavelength of the emitted light by reducing the thickness of the substrate.

### (Fifth example)

With regard to a fifth example of the present invention, the production yield for n-type GaN layer thickness formed on a substrate will be described. Three test samples were used: an invention sample L having the same structure as the invention sample A using a GaN substrate; and comparative samples M, N having structures similar to that of the comparative sample B using a sapphire substrate.

### (Invention sample L)

(l1) Operations identical to those from the corresponding steps from the invention sample A were performed.
(l2) MOCVD was performed to form the following layered structure (see Fig. 4): (a GaN substrate / a GaN buffer layer / an Si-doped n-type GaN layer 2 / an Si-doped n-type Al_{0.2}Ga_{0.8}N layer, being a clad layer / an MQW layer formed by stacking three two-layer structures consisting of a GaN layer and an In_{0.1}Ga_{0.9}N layer / an Mg-doped p-type Al_{0.2}Ga_{0.8}N layer, being a clad layer / an Mg-doped p-type GaN layer). Referring to Fig. 4, the thickness t of the Si- doped n-type GaN layer 2 was 100 nm.
(l3) - (l13) Operations similar to those from the corresponding steps from the invention sample A were performed. When etching grooves 25 are formed for element separation, an etching groove bottom 25a is formed with indentations and projections rather than being completely flat, as shown in Fig. 31. In the case of invention sample L, slight variations in the depth or the flatness of the bottom sections have minimal effect on production yield and the like since, even if the central section reaches the GaN substrate or the buffer layer, electrodes will not be formed on these sections.

### (Comparative sample M)

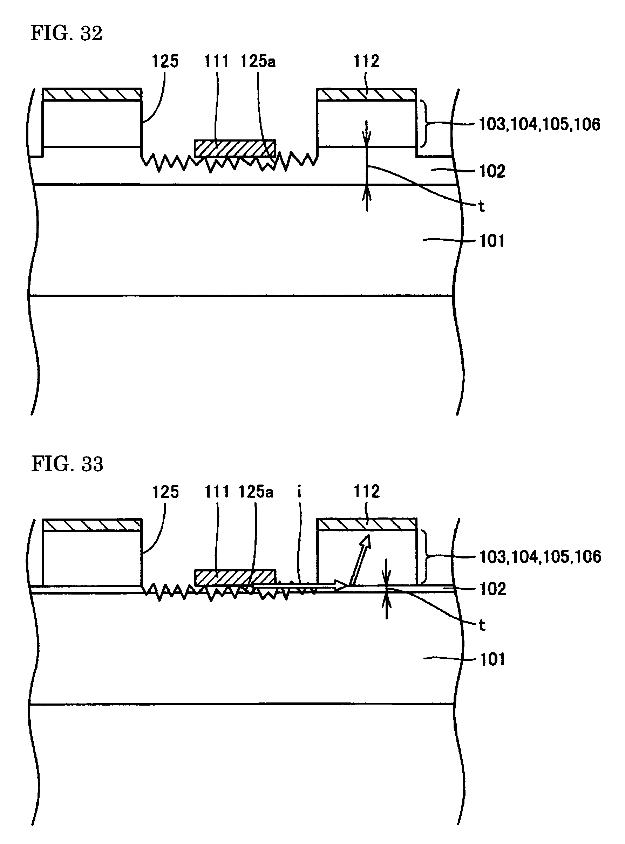

(m1) Operations similar to those from the corresponding steps from the invention sample B were performed.
(m2) MOCVD was performed to form the following layered structure on a sapphire substrate (see Fig. 8): (a sapphire substrate / a GaN buffer layer /an Si-doped n-type GaN layer / an Si-doped n-type Al_{0.2}Ga_{0.8}N layer, being a clad layer / an MQW layer formed by stacking three two-layer structures consisting of a GaN layer and an In_{0.1}Ga_{0.9}N layer / an Mg-doped p-type Al_{0.2}Ga_{0.8}N layer, being a clad layer / an Mg-doped p-type GaN layer). Referring to Fig. 8, the thickness of the Si-doped n-type GaN layer 102 is 3 microns.
(m3) - (m11) Operations identical to those from the corresponding steps from the invention sample B were performed. When etching grooves 125 are formed for element separation, an etching groove bottom 125a is formed with indentations and projections rather than being completely flat, as shown in Fig. 32. However, in the case of comparative sample M, the Si-doped n-type GaN layer 102 is thick, with a thickness of 3 microns, so that the central section does not reach the buffer layer of the sapphire substrate. As a result, slight variations in the depth or the flatness of the bottom sections have minimal effect on production yield and the like.

### (Comparative sample N)

(n1) An operation identical to those from the corresponding steps from the comparative sample B was performed.
(n2) MOCVD was performed to form the following layered structure on the sapphire substrate (see Fig. 6): (a GaN buffer layer / an Si-doped n-type GaN layer / an Si-doped n-type Al_{0.2}Ga_{0.8}N layer, being a clad layer / an MQW layer formed by stacking three two-layer structures consisting of a GaN layer and an In_{0.1}Ga_{0.9}N layer / an Mg-doped p-type Al_{0.2}Ga_{0.8}N layer, being a clad layer / an Mg-doped p-type GaN layer). Referring to Fig. 8, the thickness of the Si-doped n-type GaN layer 102 was 100 nm.
(n3) - (n4) Operations identical to those from the corresponding steps from the invention sample B were performed.
(n5) In the case of comparative sample N, a GaN-based multi-layer film having a grating constant different from that of sapphire is grown on the sapphire substrate. As a result, if the n-type GaN substrate is too thin, at 100 nm, a good multi-layer film cannot be obtained and an extremely low light emission output results.

Also, in the case of the comparative sample N, the n-electrode and the p-electrode must be formed on the same grown-film side since the sapphire substrate is an insulator. Thus, an attempt was made to expose the n-type GaN layer to form the n-type electrode by using photolithography and RIE to etch from the Mg-doped p-type layer side to the Si-doped n-type GaN layer using a Cl-based gas. However, as shown in Fig. 33, since the Si-doped n-type GaN layer in the comparative sample N is thin, at 100 nm (0.1 micron), it is not possible to expose the n-type GaN layer in a uniform manner in the wafer. As a result, the exposed surface could be the n-type AlₓGa₁₋ₓN layer or the GaN buffer layer in some cases. Wet etching using thermal phosphoric acid or the like was attempted, but the results were the same no matter what etchant was used.

### (Test results)

When light output was measured in the same manner as in the first example, an output of 8 mW was obtained from the invention sample L when a current of 20 mA was applied. Using the same current, an output of 7.2 mW was obtained from the comparative sample M. Also, similar outputs were obtained with the structure of invention sample L when the thickness of the n-type GaN layer was reduced from 3 microns to 100 nm. Also, since the n-electrode can be disposed on the N surface of the conductive GaN substrate, there is no need to expose the Si-doped n-type GaN layer.

The thickness of the film grown on the substrate of the light-emitting element depends on the wavelength and output for the element, but is generally no more than 6 microns. The thickness of the Si-doped n-type GaN layer, which is the larger part of this, can be formed thin, from 3 microns down to 100 nm, in this invention sample. As a result, with this invention sample, the cost for film growth can be dramatically reduced.

As described in the test sample processing step for the comparative sample N (n5), when the n-type GaN layer is formed thin, at 100 nm (0.1 microns), the yield for n-type GaN layer exposure becomes very bad, making the structure impractical.

Even if uniform exposure were to be made possible by future technical advances, the layer will be too thin. As in the comparative sample B of the first example, the current density of the current flowing through and parallel to the n-type GaN layer will be too high, resulting in increased heat and making it impossible to obtain practical light output (see Fig. 33). Of course, similar advantages can be obtained when the wavelength of the emitted light is changed or if a fluorescent material is used to form white light.

### (Sixth example)

In the sixth example of the present invention, the effect of the dislocation density of the GaN substrate on light output will be described. The test samples are an invention sample O with the same structure as the invention sample A and having a dislocation density of 1E6/cm² and a comparative sample P having a dislocation density of 1E9/cm².

### (Invention sample O)

(o1) An n-type GaN off-substrate with a 0.5 deg offset from the c-plane was used. The specific resistance of the GaN substrate was 0.01 Ω cm, and the dislocation density was 1E6/cm². The thickness of the GaN substrate was 400 microns.
(o2) - (o11) Operations identical to those from the corresponding steps from the invention sample A were performed.

### (Comparative sample P)

(p1) An n-type GaN off-substrate with a 0.5 deg offset from the c-plane was used. The specific resistance of the GaN substrate was 0.01 Ω cm, and the dislocation density was 1E9/cm². The thickness of the GaN substrate was the same as that of the invention sample O at 400 microns.
(p2) - (p11) Operations identical to those from the corresponding steps from the invention sample A were performed.

### (Test results)

Light output was measured as in the first example. For the invention sample O and the comparative sample P, 8 mW of output was obtained from both when a current of 20 mA was applied, while when a current of 100 mA was applied the outputs were 40 mW and 30 mW respectively. Thus, the invention sample O provided higher light emission output compared to that of the comparative sample P.

Since the invention sample O and the comparative sample P have the same specific resistance, thickness, and the like, heat generation and heat dissipation are the same. In order to confirm that the difference in light output is not due to heat, a 100 microsecond pulse current with a 1% duty cycle was applied for 1 microsecond and a comparison was made. The results from this test was the same as the results above, with 40 mW and 30 mW of output respectively when a current of 100 mA was applied.

Thus, while the mechanism by which this happened is not entirely clear, light emission output at high current densities differs based, not on the effect of heat, but on dislocation density. Also, the present inventor has confirmed through tests that similar effects can be obtained when light wavelengths and layer structures are changed as well as when white light is generated by providing a fluorescent material.

### (Seventh example)

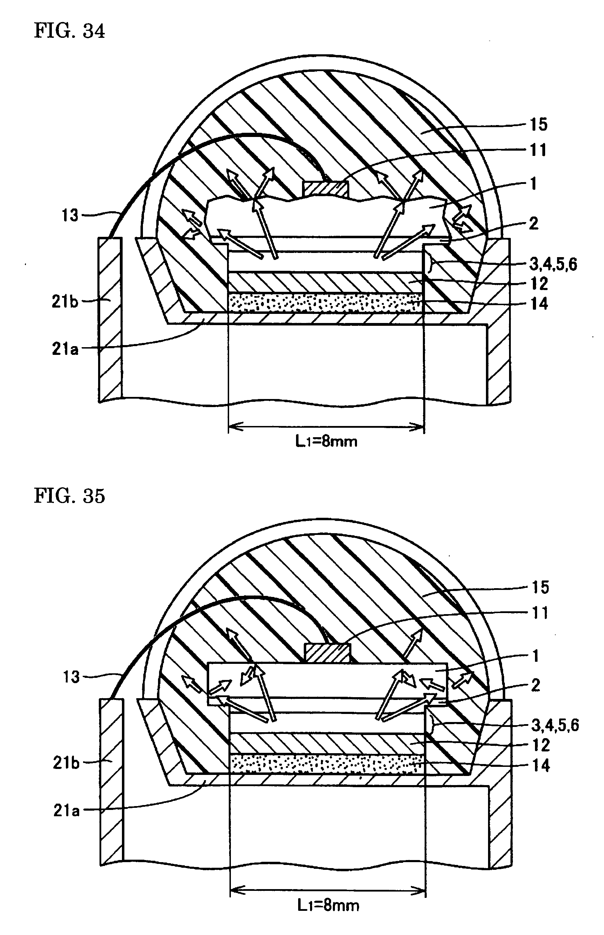

In the seventh example of the present invention, the effect on light output of applying a non-specular finish to the surface and end surface will be described. The test samples used are invention samples Q, R. The invention sample Q is the LED shown in Fig. 34 with a non-specular finish applied to the surface and end surfaces. The invention sample R is the LED shown in Fig. 35 with no non-specular finish applied.

### (Invention sample Q)

(q1) - (q7) Operations identical to those from the corresponding steps from the invention sample F were performed.
   (Step inserted between q7 and q8) A non-specular finish was applied to the N surface of the GaN substrate and the element end surfaces. The method for applying the non-specular finish was to perform wet etching or dry etching such as RIE. Besides these etching methods for applying a non-specular finish, it would also be possible to use a method involving mechanical abrasion. In this example, wet etching using an aqueous KOH solution as an etchant was performed.
   An aqueous KOH solution of 4 mol/l was kept at a temperature of 40 deg C and stirred sufficiently. The wafer was then immersed in the stirrer for 30 minutes to apply a non-specular finish to the N surface and element end surfaces of the GaN substrate.
(q8) - (q11) Operations identical to those from the corresponding steps from the invention sample F were performed.

### (Comparative sample R)

### Identical to invention sample F.

### (Test results)

Light output was measured as in the first example. For the invention sample Q and the comparative sample R, 4.8 W and 4 W of output were obtained respectively when a current of 10 A was applied. When a fluorescent material was used to generate white light and a current of 10 A was applied, the invention sample Q provided an output of 1150 1m and the comparative sample R provided an output of 960 1m. In other words, the invention sample Q provided a higher light emission output. Of course, effects were similar when the wavelength of the emitted light was varied. When the surface and end surfaces of the substrate and the n-type GaN layer are in a specular state, total internal reflection tends to take place, as shown in Fig. 35, at the surface of the GaN, which has a high index of refraction, making it difficult for light to escape out. If a non-specular finish is applied, as shown in Fig. 34, light emission efficiency to the outside can be improved.

The inventor has determined through tests that if a non-specular finish is to be applied using an aqueous KOH solution, similar effects can be obtained when the concentration is in the range of 0.1 - 8 mol/l and the temperature is in the range of 20 - 80 deg C.

### (Eighth example)

In the eighth example of the present invention, the effect of reflectivity of the p-type electrode on the light output will be described. Five test samples were used: invention samples S, T, U, V.

### (Invention sample S)

(s1) - (s6) Operations identical to those from the corresponding steps from the invention sample F were performed.
(s7) A p-electrode is formed using the following method. Starting from the bottom layer in contact with the p-type GaN layer, an Ni layer with a thickness of 4 nm was formed and an Au layer with a thickness of 4 nm was formed. Next, the structure was heated in an inert atmosphere. Then, an Ag layer with a thickness of 100 nm was formed on the Au layer. The p-electrode formed in this manner had a contact resistance of 5E-4 Ω·cm².
   A layered structure was formed similar to this p-electrode on a glass plate as follows, starting from the lowest layer in contact with the glass plate: (an Ni layer with 4 nm thickness / an Au layer with 4 nm thickness). The structure was heated in the same manner and transmittance was measured. The resulting transmittance for 450 nm incident from the Ni layer side was 70%. Furthermore, an Ag layer with a thickness of 100 nm was attached to a glass plate and reflectivity was measured. The resulting reflectivity for 450 nm incident light was 88%. The structure (an Ni layer with 4 nm thickness / an Au layer with 4 nm thickness / an Ag layer with 100 nm thickness) was formed on a glass plate with the Ni layer as the bottom layer. The same heat treatment was applied and reflectivity was measured, with the resulting reflectivity being 44% for 450 nm incident light. This reflectivity is the same as the reflectivity from when an incident light with a 450 nm wavelength is transmitted through (an Ni layer with 4 nm thickness / an Au layer with 4 nm thickness) at a transmittance of 70% and reflected at a reflectivity of 88% by an Ag layer and then transmitted through (an Ni layer with 4 nm thickness /an Au layer with 4 nm thickness) again at a transmittance of 70%.
(s8) - (s11) Operations identical to those from the corresponding steps from the invention sample F were performed.

### (Invention sample T)

(t1) - (t6) Operations identical to those from the corresponding steps from the invention sample F were performed.
(t7) A p-electrode is formed using the following method. An Ni layer with a thickness of 4 nm and an Au layer with a thickness of 4 nm were formed on a p-type GaN layer starting from the bottom. Then, the structure was heated in an inert atmosphere. Next, an Al layer with a thickness of 100 nm and an Au layer with a thickness of 100 nm were formed on the Au layer. The contact resistance of the p-electrode made in this manner was 5E-4Ω·cm².
   A layered structure was formed similar to this electrode on a glass plate as follows: (an Ni layer with 4 nm thickness / an Au layer with 4 nm thickness). The structure was heated in the same manner and transmittance was measured. The resulting transmittance for 450 nm incident from the Ni side was 70%. Furthermore, an Al layer with a thickness of 100 nm was attached to a glass plate and reflectivity was measured. The resulting reflectivity for 450 nm incident light was 84%. The following layered structure, starting from the bottom, was formed on a glass plate: (an Ni layer with 4 nm thickness / an Au layer with 4 nm thickness / an Al layer with 100 nm thickness). The same heat treatment was applied and reflectivity was measured, with the resulting reflectivity being 42% for 450 nm incident light. This reflectivity is the same as the calculated reflectivity from when an incident light with a 450 nm wavelength is transmitted through (an Ni layer with 4 nm thickness / an Au electrode layer with 4 nm thickness) at a transmittance of 70% and reflected at a reflectivity of 42% by an Al layer and then transmitted through (an Ni layer with 4 nm thickness / an Au electrode layer with 4 nm thickness) again at a transmittance of 70%.
(t8) - (t11) Operations identical to those from the corresponding steps from the invention sample F were performed.

### (Invention sample U)

(u1) - (u6) Operations identical to those from the corresponding steps from the invention sample F were performed.
(u7) For the p-electrode, Rh, which is an ohmic electrode with regard to a p-type GaN layer and also has high reflectivity, having a thickness of 100 nm is attached over the entire surface of a p-type GaN layer. The contact resistance was 5e-4 Ω·cm². Also, when the Rh of this electrode was attached to a glass plate and transmittance was measured, it was found to be 60% for 450 nm incident light.
(u8) - (u11) Operations identical to those from the corresponding steps from the invention sample F were performed.

### (Invention sample V)

(v1)-(v7) Operations identical to those from the corresponding steps from the invention sample S were performed.
   (Step inserted between v7 and v8) A step identical to the step from the invention sample Q inserted between q7 and q8 is performed.
(v8) - (v11) Operations identical to those from the corresponding steps from the invention sample S were performed.

### (Invention sample W)

The invention sample W is identical to the invention sample F.

### (Test results)

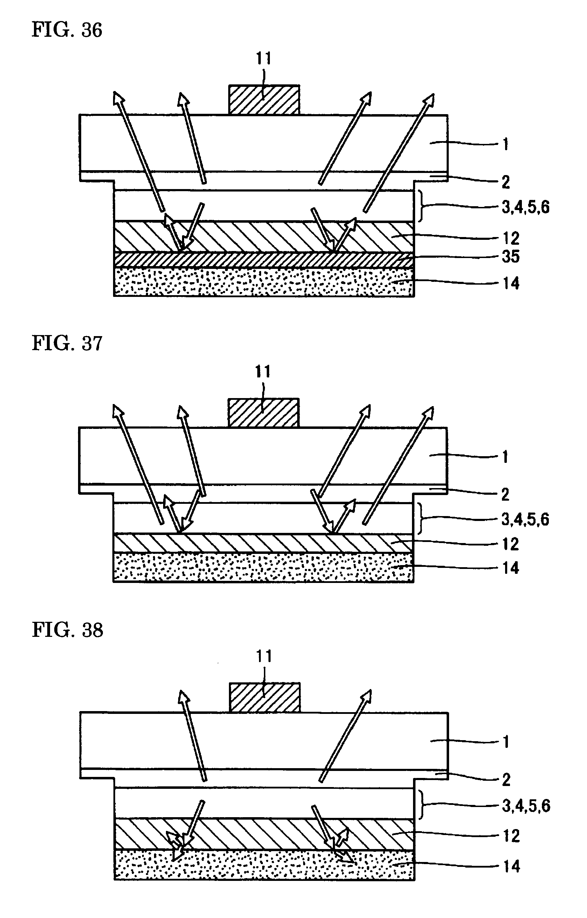

Light output was measured as in the first example. When a current of 10 A was applied, the invention samples S, T, U, V, and W provided outputs of 4.8 W, 4.8 W, 5.2 W, 5.8 W, and 4 W respectively. Fig. 36 shows a simplified drawing of reflection on the mounting side of the invention samples S, T. Fig. 37 shows a simplified drawing of reflection on the mounting side of the invention sample U. Fig. 38 shows a simplified drawing of reflection on the mounting side of the invention sample W. In the invention samples S, T, a high-reflectivity layer 35 is disposed between the p-electrode 12 and the conductive adhesive 14, while in the invention sample U the p-electrode 12 itself is a high-reflectivity material and in the invention sample V a non-specular finish is applied as well. Also, in invention sample W, reflections at the mounting side are not taken into account.

When a fluorescent material is used to form white LEDs using invention samples S, T, U, V, outputs of 864 lm, 864 lm, 936 lm, and 1044 lm respectively were obtained when a current of 10 A was applied. Based on these results, light output can be improved by forming the p-electrode from a high-reflectivity material or by interposing a high-reflectivity material between the p-electrode and the conductive adhesive to make effective use of light. In other words, light emission output can be further improved by using, at the electrode layer, a reflective film of Ag, Al, or Rh for the p-electrode itself or by inserting it between the p-electrode and the conductive adhesive. Further improvement was possible by applying a non-specular finish to the N surface and the end surfaces of the GaN substrate, as in the invention sample V.

Since reflectivity at the Ag layer or the Al layer and absorption at the Ni layer changes when the wavelength of the emitted light is changed, the effect may not be definitively generalized, but it is obvious that there will be some effect at any wavelength. Also, similar or superior advantages can be provided by using, instead of Rh, an element with a work function that is equivalent or superior and a reflectivity that is equivalent or superior.

### (Ninth example)

In a ninth example of the present invention, the relationship between the oxygen concentration of the GaN substrate and specific resistance and light transmittivity was determined. Based on this relationship, it was possible to establish the optimal GaN substrate thickness and oxygen concentration for a predetermined light emission area in a light-emitting element that is p-down mounted, i.e., when a GaN substrate acts as a light exit surface. Since, as described above, the light exit surface is a GaN substrate in p-down mounting, oxygen concentration, which has an especially significant effect on specific resistance and light transmittivity, is especially important.

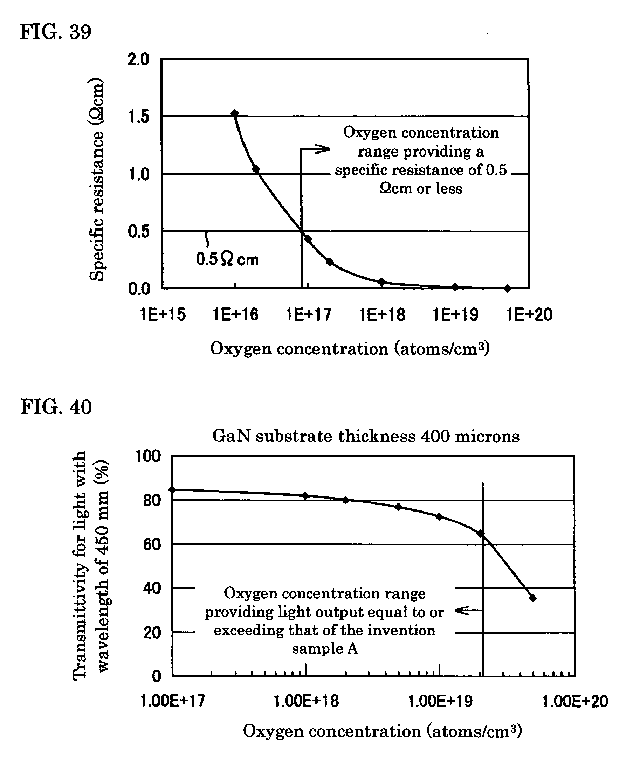

Fig. 39 shows the influence of oxygen concentration on the specific resistance of a GaN substrate. Based on Fig. 39, a specific resistance of 0.5 Ωcm or less can be achieved with an oxygen concentration of at least 1E17/cm³. Fig. 40 shows the effect of oxygen concentration on transmittivity for light with a wavelength of 450 nm when the GaN substrate is 400 microns. Based on the figure, it can be seen that the transmittivity for light with a wavelength of 450 nm drops suddenly when the oxygen concentration exceeds 2E19/cm³. Based on Fig. 39 and Fig. 40, it can be seen that increasing the oxygen concentration reduces the specific resistance of the GaN substrate and reduces the transmittivity of light, which is effective in enlarging the light exit surface. Thus, the manner in which the oxygen concentration, the thickness of the GaN substrate, the light emission plan size, and the like are selected is extremely important for GaN substrates used in p-down mounted light-emitting elements.

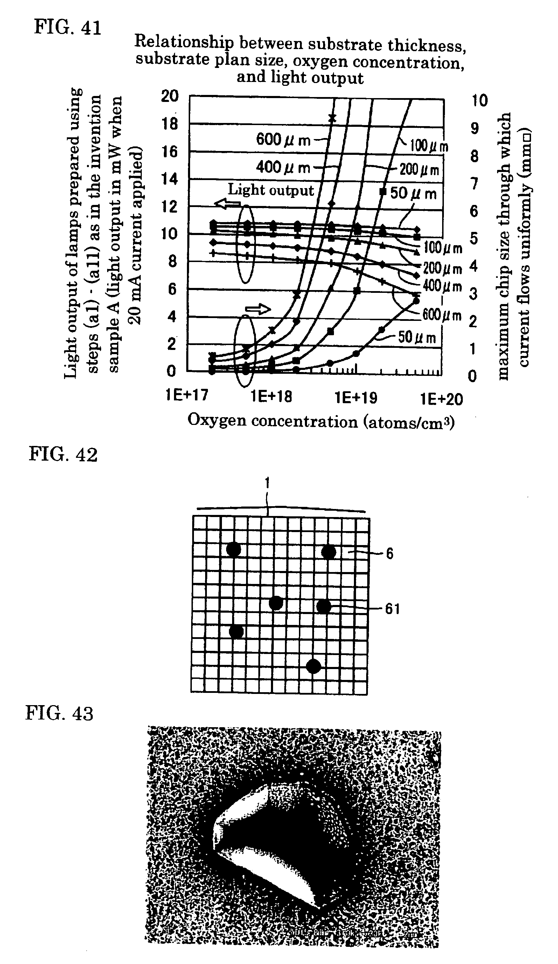

Fig. 41 shows the results of measuring lamp light output and the plan size of the area through current flows uniformly. The lamps are made from GaN substrates according to the invention sample A with different thicknesses and oxygen concentrations. Regarding lamp light output, the light output tends to decrease for thicker substrates and higher oxygen concentrations. Also, the maximum plan size through which current flows uniformly tends to increase for thicker substrates and higher oxygen concentrations.

Based on Fig. 41, as an example, if the plan size through which current flows uniformly is a square with 4 mm sides (5 mm sides) and a light output of at least 8 mW is to be obtained for the size of the invention sample A with a current of 20 mA, an oxygen concentration of at least 6E18/cm³ (at least 8E18/cm³ for a square with 5 mm sides) for a GaN substrate with a thickness of 200 microns will provide uniform light output while providing a light output of at least 8 mW for the size of the invention sample A with a current of 20 mA. In other words, when the current density is adjusted for 20 mA current for the size of the invention sample A with a square with 300 micron sides, this corresponds to the application of 3.6 A (5.6 A) for a square with 4 mm sides (5 mm sides) and uniform light output can be obtained while providing a light output of at least 1.4 W (2.3 W) proportional to the applied current when 3.6 A (5.6 A) is applied.

Also, to obtain the same target performance as a GaN substrate with 200 micron thickness for a GaN substrate with a thickness of 400 microns, an oxygen concentration of at least 3E18/cm³ can be used for a square with 4 mm sides (an oxygen concentration of at least 4E18/cm³ for a square with 5 mm sides). However, at a thickness of 400 microns, light output of at least 8 mW with the size of the invention sample A at a current of 20 mA cannot be obtained unless the oxygen concentration is no more than 2E19/cm³.

Furthermore, compared to an oxygen concentration of 2.5E18/cm³ for a uniform flow of current in a square with 4 mm sides in a GaN substrate with 600 micron thickness, the limiting value for oxygen concentration providing at least 8 mW with the size of the invention sample A at 20 mA is only slightly higher than 2.5E18/cm³. Thus, the oxygen concentration range in which the above two conditions are met is narrow. Since the oxygen concentration for uniform flow of current through a square with 3 mm sides is at least 2E18/cm³; the tolerance range for oxygen concentration is slightly broader compared to the square with 4 mm sides.

Also, based on Fig. 41, when the thickness of the GaN substrate is 200 microns - 400 microns, the oxygen concentration range for uniform flow of current through a square with 10 mm sides to obtain light output of at least 8 mW with the size of the invention sample A at 20 mA is adequately broad. At a thickness of 200 microns, it can be seen that this is possible for an oxygen concentration lower limit that is less than 2E19/cm³. Also, for a thickness of 400 microns, the oxygen concentration is at least 8E18/cm³.

More specific examples will be described. In the examples, the following samples were used.

(Invention sample S1): A GaN substrate with a thickness of 400 microns that has been n-typed with an oxygen concentration of 1E19/cm³ was used. The oxygen concentration was obtained using SIMS (secondary ion mass spectroscopy). The specific resistance of the GaN substrate was 0.007 Ωcm and the transmittivity for light with 450 nm wavelength was 72%. When using this GaN substrate to assemble a light-emitting element, the conditions were the same as those for the invention sample A except for the aspects described above. More specifically, the plan size of the GaN substrate was such that the light exit surface was a square with 0.3 mm sides (see (a1) of the first example), and (a2) MOCVD was performed to form the following layered structure on the Ga surface, which is the first main surface of the GaN substrate: (an Si-doped n-type GaN layer / an Si-doped n-type Al_{0.2}Ga_{0.8}N layer, being a clad layer / an MQW formed by stacking three two-layer structures consisting of a GaN layer and an In_{0.15}Ga_{0.85}N layer / an Mg-doped p-type Al_{0.2}Ga_{0.8}N layer, being a clad layer / an Mg-doped p-type GaN layer).

(Comparative sample T1): A GaN substrate with a thickness of 400 microns that has been n-typed with an oxygen concentration of 5E19/cm³ was used. The specific resistance of the GaN substrate was 0.002 Ωcm, and the transmittivity for light with a wavelength of 450 nm was 35%. Besides these aspects, this sample is the same as the invention sample S1.

(Comparative sample T2): A GaN substrate with a thickness of 400 microns that has been n-typed with an oxygen concentration of 2E16/cm³ was used. The specific resistance of the GaN substrate was 1.0 Ωcm, and the transmittivity for light with a wavelength of 450 nm was 90%. Besides these aspects, this sample is the same as the invention sample S1.

(Tests and results): The samples were assembled into p-down mounted light-emitting elements. When a current of 20 mA was applied, the invention sample S1 provided a light output of 8 mW. In contrast, the comparative sample T1 could only provide a light output of 4 mW and the comparative sample T2 could only provide 5 mW. The 4 mW light output of the comparative sample T1 can be explained as an output that corresponds to the transmittivity of its GaN substrate. In the comparative sample T2, the light emission from the second main surface of the GaN substrate, which is the light exit surface, was observed and variations in light intensity were found in the surface. More specifically, the light intensity was extremely high around the n-electrode while the light intensity becomes dramatically lower as the distance from the n-electrode increases. This is because the high specific resistance of the GaN substrate prevents the current flowing through the n-electrode from spreading adequately over the light-emitting element surface. This led to light emission only taking place around the p-electrode, where the current was concentrated. As a result, the overall light output for the light-emitting element of the comparative sample T2 was inferior to that of the invention sample S1.

### (Tenth example)

In a tenth example of the present invention, light output is increased by restricting dislocation bundle density in a GaN substrate in a p-down mounted light-emitting element. When the GaN substrate is formed, in order to improve the crystallinity of the majority of the substrate, dislocations, which are unavoidable, are concentrated and distributed discretely as dislocation bundles, thus improving the crystallinity of the majority of the GaN substrate in the space between the bundles. It has been found that since the GaN substrate is disposed at the light-emitting side in a p-down mounted light-emitting element, a dislocation bundle density that exceeds a predetermined value (a dislocation bundle density of 4E2/cm²), there is an unexpectedly dramatic effect on production yield for the light-emitting devices.

As shown in Fig. 42, the dislocation bundles of the GaN substrate are inherited by the p-type GaN layer 6 epitaxial film such as the p-type GaN layer and appear as cores 61 in the epitaxial film. Thus, the dislocation bundle density is roughly the same as the core density. Depending on the epitaxial film growth conditions, the cores 61 can form hole-shaped indentations as shown in Fig. 43. The density of these hole-shaped indentations has a dramatic effect on production yields in p-down mounted light-emitting devices that use a GaN substrate as the exit surface.

The samples used were as follows.

(Invention sample S2): A GaN substrate in which the average dislocation bundle distribution is 1 per 500 microns × 500 microns. This corresponds to a dislocation bundle density of 4E2/cm². Other conditions are the same as those from the invention sample S1.

(Comparative sample T3): As a comparative sample, a GaN substrate in which the dislocation bundle distribution was 10 microns × 10 microns was used. This corresponds to a dislocation bundle density of 1E6/cm². Other conditions are the same as those from the invention sample S2.

(Tests and results): Multiple light-emitting elements were made on a real production basis from the GaN substrates described above. The yield for which a light output of at least 8 mW can be obtained when 20 mA of current was applied was studied for each sample. As a result, it was found that the yield for the invention sample S2 was 95% but the yield for the comparative sample T3 was 50%. More specifically, it can be seen that a dislocation bundle density of no more than 4E2/cm² can provide a yield that is practical for production, but if the density exceeds this continuous commercial production is not practical.

The light-emitting element in devices that did not provide a light output of 8 mW were disassembled to allow chips to be retrieved and studied. Electrodes were removed by using a suitable acid solution. When the chips were observed from the p-type semiconductor layer side, multiple cases were observed where the epitaxially grown layer was not formed at the sites of the dislocation bundles of the GaN substrate. At the sites where dislocation bundles were distributed, hole-shaped indentations with a diameter of 1 micron were observed. These hole-shaped indentations were not observed in cases where the light output was at least 8 mW.

In the samples described above, when a current of 20 mA was applied at the step corresponding to the step (a7) for the invention sample A of the first example, the light-emitting elements containing hole-shaped indentations all had drive voltages of less than 1 V. This is believed to be because the hole-shaped indentations are filled by the electrodes, and the layers on the p-electrode side and the n-electrode side are short-circuited. As a result, the current flows through the entire light-emitting layer, leading to light output because of inadequate current.

### (Eleventh example)

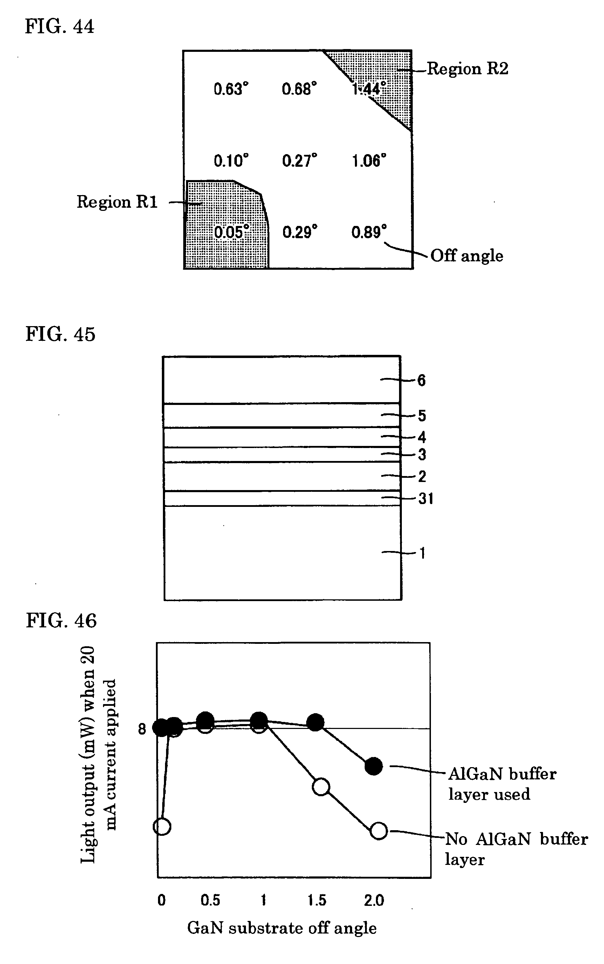

In an eleventh example of the present invention, an n-type AlGaN buffer layer and an n-type GaN buffer layer are interposed between the GaN substrate and the n-type AlGaN clad layer 3. Substrates generally have warping, but warping is especially prominent with GaN substrates. As a result, the off angle of a GaN substrate varies significantly along the substrate surface as shown in Fig. 44. Fig. 44 shows an example of distribution of off angles relative to the c-plane in a 20 mm × 20 mm GaN substrate. When an epitaxial film is formed on this GaN substrate and light-emitting elements are separated and light outputs are measured, a light output of at least 8 mW at a current of 20 mA could not be obtained for light-emitting devices formed from a region R1 at a corner having a low off angle of approximately 0.05 deg and a region R2 having a high off angle of approximately 1.5 deg. This is due to the inferior crystallinity in the epitaxial film formed on the GaN substrate.

As a result, an attempt was made, as shown in Fig. 45, to relax the difference in grating constants by forming, between the GaN substrate 1 and the AlGaN clad layer 3, a n-type AlGaN buffer layer 31 and an n-type GaN buffer layer 2, which have grating constants intermediate between the grating constants of the two layers. More specifically, the placement of the n-type AlGaN buffer layer 31 at the described position is a characteristic of this example.

The samples used were as follows.

(Invention sample S3): The GaN substrate used had continuously changing off angles from a 0.05 deg region to a 1.5 deg region on a 20 mm × 20 mm surface as shown in Fig. 42 [?Fig. 44? --transl.] The specific resistance of the GaN substrate was 0.01 Ω cm, the dislocation density was 1E7/cm², and the thickness was 400 microns. Using a GaN substrate with this type of off angle distribution, light-emitting elements were made using the different positions on the 20 mm × 20 mm substrate according to the production steps (a1) - (a11) of the invention sample A of the first example. Referring to Fig. 45, an Al_{0.15}Ga_{0.85}N buffer layer with a thickness of 50 nm is interposed between the GaN substrate 1 and the n-type GaN buffer layer 2.

(Comparative sample T4): In the GaN substrate that was used, the off angle relative to the c-plane varied continuously from an 0.05 deg region to a 1.5 deg region on a 20 mm × 20 mm surface. The specific resistance of the GaN substrate was 0.01 Ω·cm, the dislocation density was 1E7/cm², and the thickness was 400 microns. Multiple light-emitting elements were made from different positions of the substrate according to the production steps (a1) - (a11) of invention sample A of the first example. In the comparison sample T4, an n-type GaN layer was formed in contact with the GaN substrate 1 and the Al_{0.15}Ga_{0.85}N buffer layer was not formed between the GaN substrate and the n-type GaN layer.

(Tests and results): With the invention sample S3, a light output of at least 8 mW was obtained when a current of 20 mA was applied to light-emitting elements formed from 0.05 - 1.5 deg regions of the 20 mm × 20 mm GaN substrate, including the regions R1, R2 described above (see Fig. 46). However, with the comparative sample T4, light output of at least 8 mW was obtained only for light-emitting elements formed from regions with off angles of 0.1 deg - 1.0 deg. Light output did not reach 8 mW for off angles of approximately 0.05 deg and 1.5 deg.

In the invention sample S3, even when the off angle varies significantly in the GaN substrate, the placement of the Al_{0.15}Ga_{0.85}N buffer layer as described above makes it possible to form an epitaxial layer with superior crystallinity.

### (Example 11-2)

As in the eleventh example, in an example 11-2 of the present invention, an n-type AlGaN buffer layer and an n-type GaN buffer layer are placed between the GaN substrate and the n-type AlGaN clad layer 3, thus preventing the hole-shaped indentations shown in Fig. 43 to be created at the dislocation bundle sites of the GaN substrate when the epitaxial layer is formed as in the tenth example.

(Invention sample S2-2): As in the comparative sample T3, a GaN substrate with a diameter of 2 inches and 1 dislocation bundle per 10 microns × 10 microns was used. This corresponds to a dislocation bundle density of 1E6/cm². As shown in Fig. 45, an Al_{0.15}Ga_{0.85}N buffer layer with a thickness of 50 nm was interposed between the GaN substrate 1 and the n-type buffer layer 2. The other conditions were the same as those of the invention sample S2.

### (Tests and results)

After the epitaxial layer was formed, the wafer surface on the epitaxial layer side was studied with a differential interference microscope and an SEM (scanning electron microscope). As a result, it was found that there was not a single hole-shaped indentation as shown in Fig. 43. Light-emitting elements were made from the entire GaN substrate with a diameter of 2 inches, with the exception of approximately 5 mm from the outer perimeter edge of the substrate. Light-emitting elements were selected at a rate of 1 out of 50 and yield was measured for elements that could provide a light output of at least 8 mW when a current of 20 mA was applied. The result was a yield of 100%. This yield seems to indicate that, when more elements are produced, the yield would be less than 100% due to production factors other than hole-shaped indentations but close to 100%. However, in this yield test focusing on hole-shaped indentations, it was possible to obtain an exceptionally good yield of 100%.

### (Twelfth example)

In the twelfth example of the present invention, a p-type AlGaN layer with high conductivity was arranged on the outside of the following structure: (multi-quantum well 4 / p-type AlGaN clad layer 5 / p-type GaN layer 6). For the p-electrode, an Ag electrode layer having high reflectivity is formed by itself over the entire surface. Thus, other metal electrodes that take work functions and the like are not used. Since this structure provides high reflectivity on the down-side bottom section, absorption of light resulting from having other metal electrodes formed is reduced, thus improving light emission efficiency.

The samples were as follows.

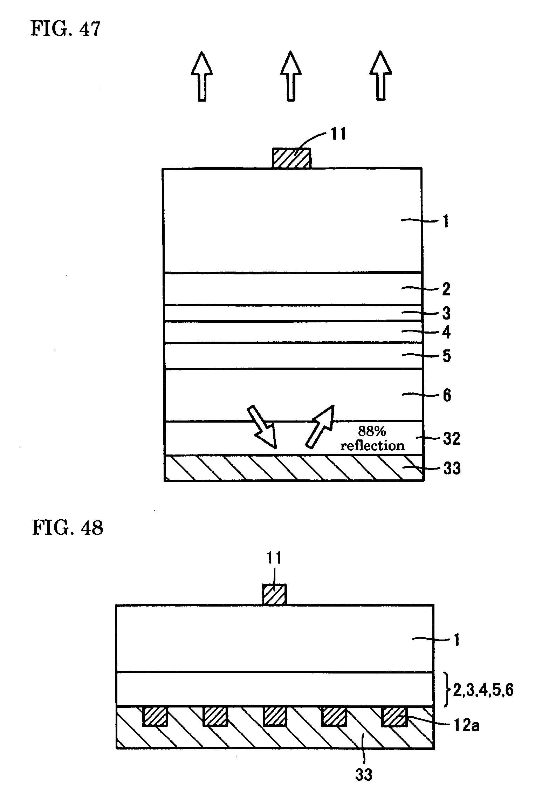

(Invention sample S4 (see Fig. 47)): As in the invention sample A, the following layered structure is formed on a GaN substrate on the Ga surface, which is the first main surface: (an MQW 4 / an Mg-doped p-type Al_{0.2}Ga_{0.8}N layer 5, being a clad layer / an Mg-doped p-type GaN layer 6 / an Mg-doped InGaN layer 32 having a thickness of 5 nm). In this layered structure, the Mg-doped InGaN layer 32 that is in contact with the Mg-doped p-type GaN layer 6 and that has a thickness of 5 nm is a unique characteristic. Furthermore, while an Ni/Au electrode layer is formed at processing step (a7) in the invention sample A of the first example, the processing step (a7) is not performed here and instead an Ag electrode layer 33 having a thickness of 100 nm is formed.

(Comparative sample T5): In the structure of the invention sample A of the first example, an Ag electrode layer having a thickness of 100 nm adjacent to the Ni/Au electrode layer was added.

(Tests and results): In the invention sample S4, the acceptor level is low because of the p-type InGaN layer 32 adjacent to the p-type GaN layer 6. As a result, the carrier concentration is higher, and even if the Ag reflective film 33, which has a work function that is not especially high, is formed adjacent to the p-type InGaN layer 32 as the p-electrode, the contact resistance between the Ag reflective film 33 and the p-type InGaN layer 32 does not become especially high. The drive voltage for the light-emitting element of the invention sample S4 and the drive voltage for the light-emitting element of the comparative sample T5 were compared, but the difference was insignificant, at less than 0.05 V.

In the invention sample S4, a light output of 11.5 mW can be obtained when a current of 20 mA is applied, while the light output was 9.6 mW for the comparative sample T5. The light output had been 8 mW for the invention sample A.

This high light output is obtained in the invention sample S4 because the light going from the light-emitting layer toward the p-semiconductor layer is not absorbed by an Ni/Au electrode layer since there is no Ni/Au electrode layer, and is instead reflected by the Ag layer, which has a reflectivity of 88%. In the comparative sample T5, however, at the p-electrode layer there is low light reflectivity = 70% absorption by Ni/Au × Ag reflectivity × reabsorption 70% = 44%. As a result, in the invention sample S4, the light output that can be extracted to the outside was greater than that of the comparative sample T5 by a factor of 1.2.

In this example, an Ag film was used as the p-electrode, but any material can be used as long as it has a high reflectivity and the contact resistance with the p-type InGaN layer 32 is not so high. For example, Al or Rh can be used.

### (Thirteenth example)

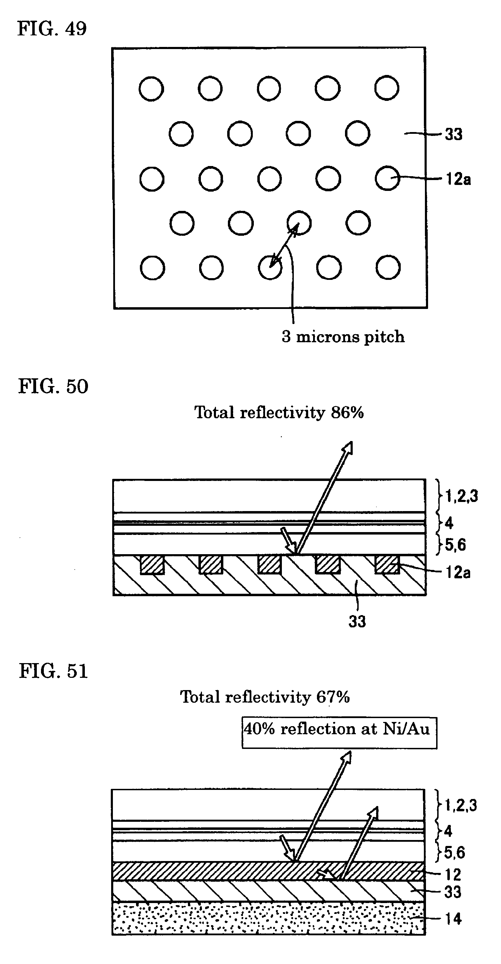

In a thirteenth example of the present invention, light output is improved by forming a p-electrode by discretely arranging Ni/Au layers, which have a low contact resistance with the p-type GaN layer, and covering this with an Ag film to fill the gaps. Fig. 48 is a cross-section drawing that focuses on the p-electrode. Ni/Au electrode layers 12a are formed discretely at a predetermined chip on a down-side bottom surface of the epitaxial layer. An Ag layer 33 is formed to fill the spaces between the layers and cover the down-side bottom surface of the epitaxial layer and the Ni/Au electrode layers 12a. Fig. 49 is a plan drawing showing the p-electrode, with the section above the p-electrode being transparent.

A typical pitch for the discrete Ni/Au electrode layers 12a is 3 microns. A 3 micron pitch is based on the fact that, in a standard p-type GaN layer or p-type AlGaN clad layer, the specific resistance of the layer results in a current flow range with a diameter of about 6 microns. In other words, with a 3 micron pitch, current from one discrete electrode can reach to an adjacent discrete electrode. A pitch of 3 microns or less would be preferable to allow the current to flow through the electrode layer thoroughly, but a pitch that is too small may lead to the discretely arranged Ni/Au electrode layers reducing the effective light extraction.

For example, if the area ratio of the discrete Ni/Au electrodes is 20%, with the p-electrode structure shown in Fig. 48 and Fig. 49, light reflectivity (calculated) = 88% reflectivity × 80% area ratio + 40% reflectivity × 20% area ratio = 78% (calculated). P-electrodes having the structure described above was actually made based on this calculation and light output was measured. The samples were as follows.

(Invention sample S5): The production steps were the same as those for the invention sample A of the first example, but, at the p-electrode production step (a7), an Ni layer with a thickness of 4 nm was formed in contact with the p-type GaN layer, and an Au layer was formed on top this over the entire surface with a thickness of 4 nm. Next, patterning was performed using a resist mask to form discretely distributed Ni/Au electrodes (see Fig. 48, Fig. 49). Next, the structure was heated in an inert gas atmosphere so that the contact resistance was 5E-4 Ω·cm². Then, an Ag layer was formed over the entire surface to fill the gaps between the Ni/Au electrodes and to cover the Ni/Au electrodes, forming a reflective electrode. The area ratio of the discretely arranged Ni/Au layers on the p-type GaN layer was 20%, and the area ratio for the Ag was 80%. Also, the Ni/Au electrode layers 12 were arranged at a pitch of 3 microns (see Fig. 50).

(Comparative sample T6): A layered structure was formed on a GaN substrate using the same production steps as in the invention sample A of the first example. For the p-electrode, an Ni/Au layer was formed in contact with the p-type GaN layer over the entire surface according to the production step (a7), and heat was applied. Next, unlike the invention sample A, an Ag layer was formed in contact with the Ni/Au layer over the entire surface (see Fig. 51).

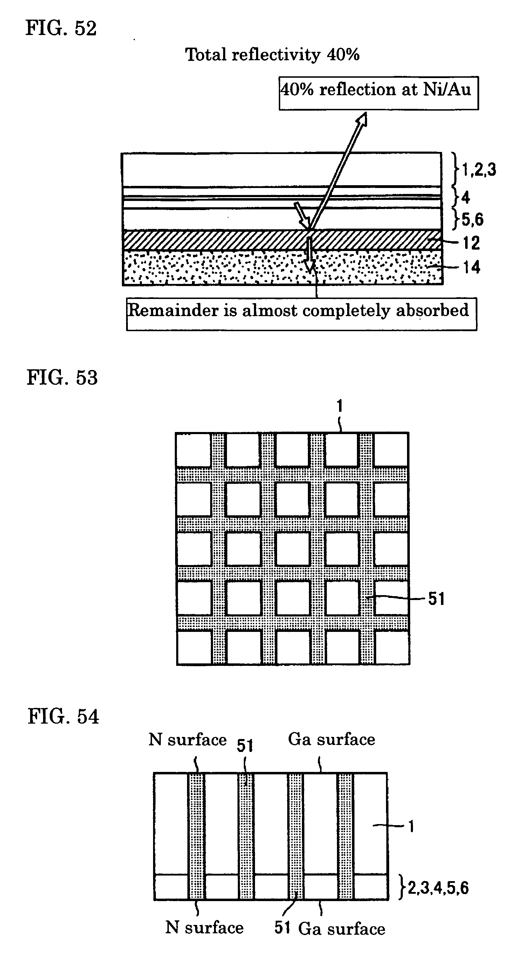

For comparison, Fig. 52 shows the reflection behavior in a light-emitting element identical to the invention sample A when light goes toward the down side.

(Tests and results): A current of 20 mA was applied to the light-emitting elements prepared as described above and light output was measured. With the invention sample S5, a light output of 11.5 mW was obtained, but the output was 9.6 mW for the comparative sample T6. Also, of the light going from the light-emitting layer to the mount side (down side), the proportion that is reflected by the p-electrode and exits from the exit surface is 86% in this invention sample (see Fig. 50). In contrast, the proportion was 67% for the comparative sample T6 (Fig. 51). In the invention sample A, the proportion was 40% (Fig. 52).

In the invention sample S5, of the light going toward the down side, 80% of the light is reflected at a reflectivity of 88% by the Ag, which occupies 80% of the p-electrode, and 20% of the light is reflected at a reflectivity of more than 40% (the reflectivity is not simply 40%) by the Ni/Au layers, which occupy 20% of the p-electrode. As a result, the proportion described above is 86% for the invention sample S5. In the comparative sample T6, the light is further reflected by the Ag layer positioned on the down side of the Ni/Au layer, and this reflection makes the proportion greater than that of the invention sample A.

Of course, in the broadest sense, the comparative sample T6 constitutes an invention sample. It is referred to as a comparative sample here simply to facilitate the description of this example.

The Ni/Au electrode layer described above can be replaced with a Pt electrode layer or a Pd electrode layer. Also, the reflective electrode Ag layer can be replaced with a Pt layer or an Rh layer.

Similarly, light output higher than that of the comparative sample T6 can be obtained according to the area ratio, e.g., the light output is 11.8 mW for 20 mA when the Ni/Au electrode area ratio is 10% and the light output is 10.6 mW for 20 mA when the Ni/Au electrode area ratio is 40%. However, if the Ni/Au electrode area ratio is 2%, which is less than 10%, a light output of only 9.6 mW, which is the same as that of the comparative sample T6, was obtained, and the inventor has confirmed through tests that there was extremely prominent unevenness in light emission around the Ni/Au electrodes.

### (Fourteenth example)

In the fourteenth example of the present invention, multiple parallel plate-shaped inverted crystal domains propagating from the GaN substrate to the epitaxial layer were removed, and p-electrodes were disposed at the gaps of the plate-shaped inverted crystal domains. Stripes distributed parallel to the thickness axis of the GaN substrate appear on the main surface of the GaN substrate, and the inverted crystal domains propagate to the epitaxial layers 2, 3, 4, 5, 6. The plate-shaped inverted crystal domains are arranged in a grid formation on the main surface, as shown in Fig. 53 and Fig. 54. When the nitride semiconductor substrate is prepared, the regions where dislocation bundles (i.e., cores) are collected have an inverted crystal arrangement relative to the surrounding areas. Thus, plate-shaped inverted crystal domains and dislocation bundles are similar in that the crystal arrangements thereof are inverted relative to the surrounding areas. The difference is that in dislocation bundles the dislocations are concentrated in string shapes or line shapes with a width, so that the inverted crystal domains are string-shaped, while in the plate-shaped inverted crystal domains they are plate-shaped. In other words, in inverted crystal domains, dislocations are distributed at a high density in plane-shaped domains having a thickness.

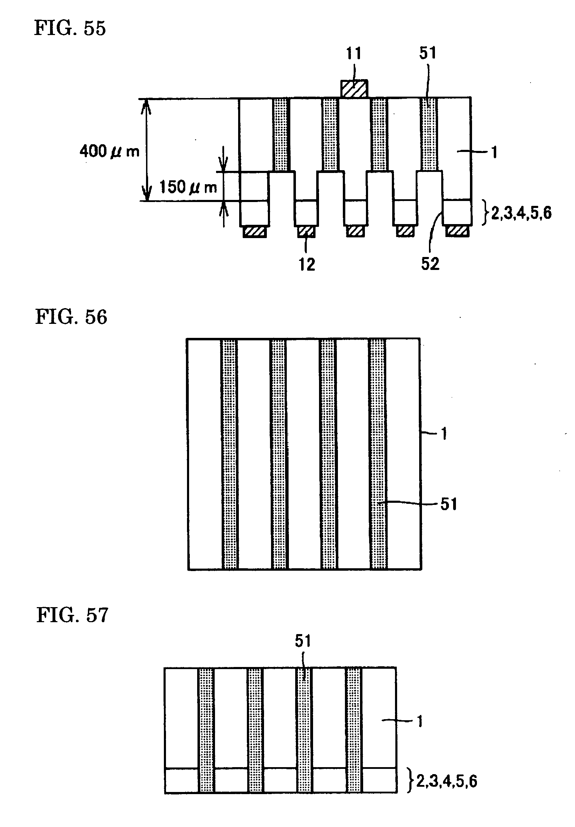

In this example, the inverted crystal domains in the epitaxial layers were completely eliminated, and the inverted crystal domains of the GaN substrate were removed to a predetermined depth, the epitaxial layers are separated, and p-electrodes are provided for each separated epitaxial layer (see Fig. 55). The plate-shaped inverted crystal domains can be formed from grid-shaped inverted crystal domains in which plate-shaped inverted crystal domains intersect as shown in Fig. 53. Alternatively, a parallel arrangement distributed in a single direction on the main surface is also possible, as described later.

(Invention sample S6): In the GaN substrate shown in Fig. 53 and Fig. 54, the first main surface on the epitaxial layer side is a surface with a surface orientation of (0001), i.e., a c-plane. The inverted crystal domain that is in surface symmetry with the first main surface is a (000-1) plane, i.e., a -c plane, and is grown with the c axis inverted. At the c-plane, the surface is a Ga surface, where Ga atoms are arranged, and at the inverted crystal domain, the surface is an N surface, where N atoms are arranged. In the invention sample S6, a GaN substrate was used in which inverted crystal domains were arranged in a grid pattern with a width of 30 microns every 100 microns. The inverted crystal domains propagate to the epitaxial films formed on the GaN substrate.

In this GaN substrate, a layered structure was formed using the same method as in the invention sample A (see steps (a1)- (a6) of the invention sample A). In place of the p-electrode forming step (a7), the following operation is performed. A mask pattern is used on the p-type GaN layer to cover only the inverted crystal domains propagated as shown in Fig. 54. After forming p-electrode layers only on the c-plane regions between the masks, the mask pattern is removed.

Next, a mask is used to cover the entire surface of the second main surface (back surface) of this GaN substrate, and this semiconductor substrate is kept in 8 N (normality) KOH at 80 deg C to etch away the inverted crystal domains on the first main surface side by etching through the epitaxial layers such as the p-type GaN layer and into the GaN substrate, forming grooves 52. The plate-shaped inverted crystal domains 51 can be easily etched with KOH since they are dislocation concentration areas with high dislocation density. The depth of etching into the GaN substrate is to a position 150 microns in to the GaN substrate side from the boundary surface between the epitaxial layers and the GaN substrate. Then, the mask is removed and an insulating film was deposited to fill the grooves 52 (Fig. 55).

(Tests and results): The invention sample S6 was used to prepare light-emitting elements, which provided a light output of 9.6 mW when a current of 20 mA was applied. This is greater than the 8 mW light output of the invention sample A by a factor of 1.2.

As described above, the plate-shaped inverted crystal domains in the invention sample S6 were arranged in a grid shape, but the plate-shaped inverted crystal domains do not need to be formed in a grid shape. As shown in Fig. 56 (plan drawing) and Fig. 57 (cross-section drawing), the main surface of the GaN substrate can be formed with parallel plate-shaped inverted crystal domains arranged in only one fixed direction. Also, point-shaped (in practice, a plane or a small circle) inverted crystal domains can be formed in a regular arrangement on a nitride semiconductor substrate, and, as in the invention sample S6, a light output higher than that of the invention sample A will be obtained based on the size and depth of the etching holes.

### (Fifteenth example)

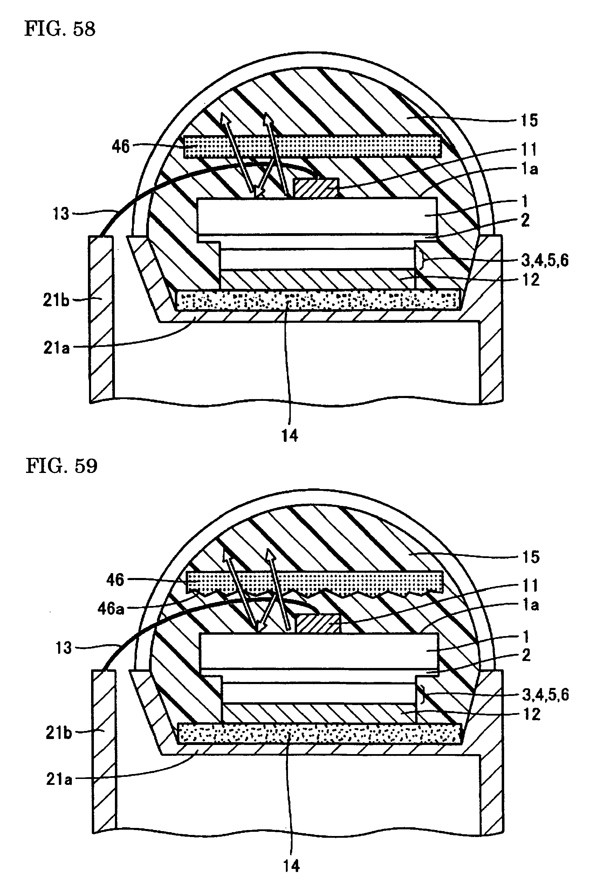

As shown in Fig. 58, in the fifteenth example of the present invention, a fluorescent plate 46 is disposed facing the GaN substrate 1 above the semiconductor chip and is sealed with a resin 15. The innovation is in the placement of the fluorescent plate facing the GaN substrate, which serves as the radiation surface in a p-down mounted structure. The samples used are invention samples S7, S8 shown in Fig. 58 and comparative sample T7.

(Invention sample S7): The invention sample S7 is made essentially according to the production steps for the invention sample F of the third example. As shown in Fig. 58, the fluorescent plate 46 is disposed above the p-down mounted chip so that it faces the back surface of the GaN substrate 1, and the structure is sealed with the epoxy-based resin 15 to form a white light-emitting device.

The fluorescent plate 46 was made in the following manner. Halogen transport was performed to prepare bulk ZnSSe crystals in which I (iodine) is diffused. The bulk ZnSSe crystal was heated in a Zn, Cu atmosphere to diffuse Cu in the ZnSSe. Next, this bulk ZnSSe crystal was abraded to a thickness of 0.5 mm using a coarse grinder, after which it was cut to fit a lead frame. The roughness of the surface and back surface of the fluorescent plate prepared in this manner was Rmax=1 micron.

(Invention sample S8): In the invention sample S8, indentations and projections were formed on a surface 46a of the fluorescent plate 46 facing the GaN substrate (see Fig. 59). The height of the indentations and projections was set to 2 microns and the average pitch of the indentations and projections was set to 5 microns. Other structures were the same as those of the invention sample S7.

(Comparative sample T7): As shown in Fig. 60, the fluorescent plate 46 was disposed above a p-top mounted chip so that it faces the chip, and the structure was sealed with the epoxy-based resin 15 to form a white light-emitting device.

(Samples and results): When a current of 10 A was applied to the light-emitting devices formed from GaN substrates as described above, the luminance of the resulting light emissions was as follows. High luminances were obtained for the invention sample S7, at 800 1m, and for the invention sample S8, at 880 1m. The luminance of the comparative sample T7 was 540 1m. These results indicated that a higher luminance can be obtained by placing a fluorescent plate facing a p-down mounted GaN substrate compared to placing a fluorescent plate over a p-top mounted structure, and also that making the surface of the fluorescent plate facing the GaN substrate rougher provides further improvement in luminance.

### (Sixteenth example)

In a sixteenth example of the present invention, the following were prepared: invention samples S9, S10, S11, which are LEDs with structures essentially similar to the invention sample V according to the present invention; a comparative sample T9, which is an LED equipped with a structure essentially similar to that of the comparative sample D already mentioned, and a comparative sample T10, which is an LED equipped with a structure essentially similar to that of the comparative sample B. These LEDs were used to make automotive headlamps. This will be described in further detail below.

First, the structures of the invention samples S9, S10, S11 are as follows.

(Invention sample S9): The LED of the invention sample S9 was equipped with a structure essentially similar to that of the invention sample A shown in Fig. 3. In the invention sample S9, the GaN substrate 1 (see Fig. 3) was n-typed by oxygen doping. The oxygen concentration of the GaN substrate 1 was 6E18/cm³. Also, the thickness of the GaN substrate 1 was set to 400 microns. LEDs serving as light-emitting devices were prepared using steps similar to steps (v1) - (v11) of the invention sample V. The chip size of the invention sample S9 was 2.5 mm□ (the light exit surface of the chip LED is 2.5 mm□ (a square with sides 2.5 mm long)), and the shape of the light emission layer is 2.5 mm□ (i.e., L1=2.6 mm in Fig. 3). As a result, the area of the MQW light-emission section is 6.25 mm². Also, the diameter of the n-electrode 11 (see Fig. 11) was set to D=0.83 mm. This was set so that the ratio of the MQW light-emitting section size to the size of the n-electrode 11 in the invention sample S9 will be identical to the ratio of the MQW light-emitting section size to the n-electrode 11 size in the invention sample A. Then, current is applied to the LED of the invention sample S9 and the relationship between light output and applied current was studied. Measurements were made essentially in the same manner as in the other examples. The LED of the invention sample S9 was mounted in an integrating sphere, a predetermined current was applied, the light was focused, and the light output value from the detector was measured. As a result, a proportional relationship was determined between the light output and the applied current up to 6.88 A, which corresponds to a current density of 110 (A/cm²) (the light output for this was 4 W). The light output from the LED was saturated for applied currents of 6.88 A and higher, so it is believed that applied current = 6.88 A is the thermal limit. An LED that emits white light (a white LED) was prepared using a fluorescent material that provides 250 lm per 1 watt (W) of 450 nm light output. The positioning of the fluorescent material was similar to that used for the LED shown in Fig. 18. Using this white LED, a headlamp as shown in Fig. 2 was prepared. However, a single LED was installed in the headlamp.

(Invention sample S10): As in the invention sample S9, steps essentially similar to those of the invention sample V were used to form a structure similar to that of the invention sample V (i.e., the structure was essentially the same as that of the invention sample S9). However, in the invention sample S10, the oxygen concentration in the GaN substrate 1, the chip size, the area of the MQW light emitting section, and the size of the n-electrode 11 were different from those of the invention sample S9. More specifically, in the invention sample S10, the oxygen concentration of the GaN substrate 1 was 4E18/cm³, the chip size was 1.4 mm□, the area of the MQW light-emitting section was 1.96 mm², and the diameter D of the n-electrode 11 was 0.47 mm. Also, in the invention sample S10, an epitaxial multilayer film with an internal quantum efficiency of 50% was used. Then, current was applied to the LED of the invention sample S10 and the relationship between light output and applied current was studied. Measurements were made in the same manner as in the invention sample S9. As a result, it was found that there was a proportional relationship between the light output and the applied current up to 2.16 A, which corresponds to a current density of 110 (A/cm²) (the light output for this value was 1.25 W). Since the light output that could be obtained from the LED was saturated when the applied current was 2.16 A or higher, it is believed that the applied current = 2.16 A is a thermal limit. Then, an LED that emits white light (a white LED) was prepared using a fluorescent material that provides 250 1m per 1 watt (W) of 450 nm light output. The positioning of the fluorescent material was similar to that used for the LED shown in Fig. 18. Using this white LED, a headlamp as shown in Fig. 2 was prepared. However, as in the example [?invention sample? --transl.] S9 a single LED was installed in the headlamp.

(Invention sample S11) As in the invention sample S10, steps essentially similar to those for the invention sample V were performed to form a structure similar to that of the invention sample V. However, while the invention sample S10 used an epitaxial multi-layer film with an internal quantum efficiency of 50%, the invention sample S11 used an epitaxial multi-layer film with an internal quantum efficiency of 78%. Also, chip size was 2.0 mm□. Current was applied to the LED of the invention sample S11 and the relationship between light emission efficiency and applied current was studied. The measurements were made in the same manner as in the invention sample S9. As a result, a proportional relationship was determined between the light output (light emission intensity) and the applied current (injected current) up to 4.4 A (which produced 4 W light output), which corresponds to a current density of 110 (A/cm²). Even if the applied current is at or greater than 4.4 A, the light emission that can be obtained from the LED is saturated, so it is believed that the condition applied current = 4.4 A is the thermal limit. A fluorescent material that provides 250 1m per 1 watt (W) of 450 nm light output was used to form a white LED that emits white light. The arrangement of the white LED was the same as that shown in the LED in Fig. 18. This white LED was used to make a headlamp as shown in Fig. 2. However, as in the example [?invention sample? --transl.] S9 a single LED was installed in the headlamp.

The comparative samples T9, T10 were formed with the following structures.

(Comparative sample T9): An LED for the comparative sample T9 having essentially the same structure as that of the comparative sample D was obtained using steps essentially similar to the production steps (d1) · (d11) of the comparative sample D. However, a chip size of 1.4 mm□ was used. Also, the dimension L4 of the section of the n-type GaN layer forming the n-electrode was set to 0.7 mm. This was set so that the ratio of the MQW light-emitting section size to the size of the n-electrode 11 in the comparative sample T9 will be identical to the ratio of the MQW light-emitting section size to the n-electrode 11 size in the comparative sample D. As a result, the area of the MQW light-emission section was set to 1.47 mm². As in the invention sample S10, the relationship between light output and applied current was studied for the comparative sample T9. As a result, it was found that when a current of 2.16 A was applied as in the invention sample S10 to the comparative sample T9, the light output was only 0.54 W. Then, a white LED was prepared to serve as a comparative sample that emits white light by using a fluorescent material that provides 250 1m per 1 watt (W) of 450 nm light output. The positioning of the fluorescent material was similar to that used for the LED shown in Fig. 18. Using this white LED, a headlamp as shown in Fig. 2 was prepared. However, a single LED was installed in the headlamp.

(Comparative sample T10): An LED for the comparative sample T10 was obtained having a structure essentially similar to that of the comparative sample B using steps essentially similar to the production steps (b1) - (b11) of the comparative sample B. As a result, the area of the MQW light-emitting section was 0.0675 mm². As in the comparative sample T9, the relationship between the light output and applied current was studied for the LED of the comparative sample T10. As a result, it was found that the light output was 25 mW when a current of 100 mA was applied. Then, a white LED was prepared to serve as a comparative sample that emits white light by using a fluorescent material that provides 250 lm per 1 watt (W) of 450 nm light output. The positioning of the fluorescent material was similar to that used for the LED shown in Fig. 18. Using this white LED, a headlamp as shown in Fig. 2 was prepared. However, as in the comparative sample T9, a single white LED was installed in the headlamp.

### (Tests and results)

Luminance was measured for the headlamps of the invention samples S9, S10, S11, and the comparative samples T9, T10. The resulting measurements indicated that with the invention sample S9, for a current of 6.88 A, which is the limit current that exhibits IL linearity, luminous flux was 1000 lm and luminance was 60 cd/mm². The measurements also indicated that, with the invention sample S10, for a current of 2.16 A, which is the limit current that exhibits IL linearity, luminous flux was 310 lm and luminance was 21 cd/mm². The measurements also indicated that with the invention sample S11, for a current of 4.4 A, which is the limit current that exhibits IL linearity, luminous flux was 1000 lm and luminance was 60 cd/mm². With the comparative sample T9, for a current of 2.16 A, which is the same current as in the invention sample S10, luminous flux was 135 1m and luminance was 9 cd/mm². With the comparative sample T10, for a current of 100 mA, which is the current at which the light output is saturated, the luminous flux was 6.3 1m and the luminance was 0.38 cd/mm².

Thus, it can be seen that the invention samples S9 and S11 can provide, with a single light-emitting device (LED), a luminous flux (300 - 1000 1m) and luminance comparable to a conventional headlamp. Also, with the LED used in the headlamp of the invention sample S10, combining 1 - 3 of these LEDs can provide a luminous flux and luminance comparable to a conventional headlamp.

As in the comparative sample D described earlier, the comparative sample T9 has a structure that is much more complex than that of the invention sample S10 described above, resulting in a more complex production process. Thus, the production cost of the comparative sample T9 is extremely high compared to that of the invention sample S10, while the comparative sample T9 can only provide a light output of approximately 45% of that of the invention sample S10. Thus, in order to provide a predetermined luminous flux, more LEDs would be needed compared to when the invention sample S10 is used. As a result, since more space is required to install LEDs in the headlamp and since a greater number of parts is required, the production cost of the headlamp is increased further.

Also, in terms of running costs, the light-emission efficiency of the comparative sample T9 is approximately 45% lower than that of the invention sample S10, the headlamp of the comparative sample T9 has higher power consumption than the headlamp of the invention sample S10, i.e., the running costs are higher as well.

Also, in the comparative sample T10, the LED structure is simplified as much as possible by forming the LED from a small chip. However, as described above, the luminous flux that can be obtained for each chip in the comparative sample T10 is low, and the luminous is also extremely low compared to the invention samples. Thus, in order to obtain an luminous flux comparable to that of conventional headlamps using the comparative sample T10, it would be necessary to install a large number of LEDs, i.e., 48 - 159 LEDs, for each headlamp. To use this many LEDs, a large LED installation space must be provided in the headlamp, and the increase in the number of parts also means an increase in production costs.

A standard battery installed in a vehicle such as an automobile has a voltage of 12 V. In order to obtain a luminous flux of 1000 1m, eight LEDs would be needed if the LED of the comparative sample T9 were to be used. In order to drive eight of these LEDs when they are simply connected in series, a high voltage of 24 V - 32 V would be needed. However, considering the battery power source installed in a vehicle as described above, this type of simple series connection cannot be used. More specifically, to provide a predetermined luminous flux using the LEDs of the comparative sample T9, it is necessary to use a complex driver circuit in which series and parallel connections of the eight LEDs would be combined in order to meet the restrictions imposed by the battery. This type of complex circuitry would increase production costs for the headlamp. Furthermore, with the comparative sample T10, it is believed that the number of LEDs required would be so high that the structure of the required driver circuit would be impractical. With the invention samples S9 - S11, on the other hand, the necessary luminous flux (e.g., 1000 1m) could be obtained using 1 - 3 LEDs. As a result, there is no need to use a complex driver circuit as described above. In other words, increased headlamp production costs caused by this type of complex driver circuitry can be avoided.

Even if a headlamp were to be made using LEDs according to the comparative sample T9, T10, or the like with a complex driver circuit that involves a combination of series and parallel connections, problems with illumination quality would be unavoidable, e.g., uneven color caused by variations in the degree of deterioration between the multiple LEDs and uneven color caused by non-uniform temperature distribution due to differences in heat dissipation between LEDs. As a result, the lifespan, the reliability, and the yield from the production process for the headlamp would be inferior compared to a headlamp that uses the invention samples S9 - S11.

In the comparative sample T9 and the like, it is believed that a luminous flux comparable to a conventional headlamp can be obtained by increasing the chip size to compensate for lower light emission efficiency. However, in such cases: 1) since the size of the LED will be greater compared to those of the invention sample S9 - S11, more space will be required to install the LEDs; 2) in the case of the comparative sample T9 and the like, the electrode structure becomes more complex for larger chip sizes so that uniform light emission and head dissipation in the chip becomes more difficult; 3) power consumption will be unavoidably higher than with the invention sample S9 - S11; and the like. As a result, it is believed that it would not be practical to increase chip size to compensate for lower light-emission efficiency in the comparative samples described above.

Since a GaN substrate, which is a conductive substrate, is used in the invention samples S9 - S11, there is no need for a protection circuit to protect against electrostatic potential (e.g., it is possible to connect just a power supply and a control circuit to the GaN substrate LED). As a result, the number of parts used in the headlamp can be reduced and parts cost can be reduced. Also, since there is no need to reserve space in the headlamp for placement of the protection circuit, the headlamp can be made more compact or a greater degree of freedom can be provided in the design of the headlamp. In the invention samples S9 - S11, the light-emission efficiency of the epitaxial multi-layer film and the conversion efficiency of the fluorescent material can have relatively standard values. Of course, if these values are increased, the chip can be made smaller making it possible, e.g., to provide luminous flux of 300 1m or 1000 1m with a 1 mm□ chip.

Next, although there will be some overlap with the embodiments and examples described above, the examples of the present invention will be listed and described below.

A headlamp 82 according to the present invention shown in Fig. 1 and Fig. 2 is an headlamp for a vehicle equipped with a light source (a group of LEDs formed from multiple LEDs 84) containing one or more light-emitting devices (LED 84) and a base member (a pedestal 86 and a rear case 92) for securing the light source to the vehicle. The LED 84 includes: a nitride semiconductor substrate (the GaN substrate 1); an n-type nitride semiconductor layer (the n-type AlₓGa₁₋ₓN layer 3) on the first main surface side of the nitride semiconductor substrate; a p-type nitride semiconductor layer (the p-type AlₓGa₁₋ₓN layer 5) positioned further away from the nitride semiconductor substrate compared to the n-type nitride semiconductor layer; and a light-emitting layer (the MQW (multi-quantum well) 4) positioned between the n-type nitride semiconductor layer and the p-type nitride semiconductor layer. In this light-emitting device, the specific resistance of the nitride semiconductor substrate is no more than 0.5 Ω·cm, the p-type nitride semiconductor layer side is down-mounted, and light is emitted from the second main surface 1a, which is the main surface opposite from the first main surface of the nitride semiconductor substrate.

In this structure, the n-electrode 11 is disposed on the second main surface 1a of the GaN substrate 1 so that current is able to flow through the entire nitride semiconductor substrate even if the n-electrode 11 is disposed with a low covering ratio, i.e., a large opening ratio. As a result, light emission efficiency can be increased and the number of light-emitting devices needed to obtain a luminous flux in the headlamp can be reduced. This makes it possible for a relatively low-cost headlamp to be made.

In the headlamp described above, the nitride semiconductor substrate can be formed from either GaN or AlₓGa₁₋ₓN (0<x<=1). If the GaN substrate 1 s used for the nitride semiconductor substrate, a high current density can be applied, allowing high luminance (and high luminous flux) to be emitted from the light-emitting device. Also, forming the nitride semiconductor substrate from GaN or AlₓGa₁₋ₓN (0<=x<=1) means the LED for a light-emitting device is formed with a nitride semiconductor substrate having good heat conductivity, i.e., good heat dissipation properties. Thus, adequate heat dissipation is possible even when a high current density is applied, making it possible to ower the chance that the LED will be damaged by heat. As a result, the headlamp 82 can be implemented to provide light output that is stable over a ong period of time.

In this headlamp, it would be preferable for the dislocation density of the GaN substrate 1 to be no more than 1E8/cm³. In this case, current with a high current density can be applied to the GaN substrate 1. As a result, high-luminance light can be emitted from the LED 84.

In this headlamp, it would be preferable for the GaN substrate 1 or the AlₓGa₁₋ₓN substrate (0<x<=1) to have a heat conductivity of at least 100 W/(m·K). This allows the heat generated by the LED to be efficiently dissipated through the GaN substrate 1 and the like. As a result, the increase in the temperature of the LED can be limited even when a high current is applied to the LED, making it possible to implement a headlamp that can emit high-luminance light in a stable manner.

In the headlamp described above, it would be preferable for the output (luminous flux) from each LED to be at least 300 lumens (1m). This makes it possible to obtain output comparable to that of a conventional headlamp using a single light source, thus allowing one or a small number of LEDs to be used to form a headlamp having adequate light output (luminous flux).

In this headlamp, the output from a single LED can be at least 1000 lumens (1m). This makes it possible to obtain an output comparable to a conventional headlamp from a single LED, thus allowing one or a small number of LEDs to be used to form a headlamp having adequate light output (luminous flux).

In this headlamp, the size of the section of the second main surface 1a of the GaN substrate 1 that emits light (the size of the light exit surface in Fig. 3) can be at least 1 mm × 1 mm. This makes it possible to apply a current high enough for the output (luminous flux) described above to the GaN substrate 1 at a certain current density (e.g., approximately 110 A/cm²).

In this headlamp, the GaN substrate 1 can be n-typed by oxygen doping, and the oxygen concentration of the GaN substrate 1 can be at least 2E18 /cm³ oxygen atoms and no more than 2E19/cm³. The thickness of the GaN substrate 1 can be at least 200 microns and no more than 400 microns. Since current can flow uniformly through this GaN substrate 1, the LED can emit light adequately from roughly the whole second main surface 1a of the GaN substrate 1.

In the headlamp described above, the size of the section of the second main surface 1a of the GaN substrate 1 that emits light (the size of the light exit surface of Fig. 3) can be at least 2 mm × 2 mm. This makes it possible to apply a current high enough for the output (luminous flux) described above to the GaN substrate 1 at a certain current density (e.g., approximately 110 A/cm²).

In the headlamp described above, the GaN substrate 1 can be n-typed by oxygen doping, and the oxygen concentration of the GaN substrate 1 can be at least 3E18/cm³ oxygen atoms and no more than 2E19/cm³. The thickness of the GaN substrate 1 can be at least 200 microns and no more than 400 microns. Since current can flow uniformly through this GaN substrate 1, the LED can emit light adequately from roughly the whole second main surface 1a of the GaN substrate 1.

In the headlamp described above, the electrostatic withstand voltage of the LED can be at least 3000 V. Also, in this headlamp there is no need to provide a special protection circuit to protect the LED from transient voltage or static discharge between the GaN substrate 1 and the side of the p-type AlₓGa₁₋ₓN layer 5 serving as the down-mounted p-type nitride semiconductor layer. Also, in this headlamp, there is no need to provide a power shunting circuit containing a zener diode to handle transient voltages or electrostatic discharge. Compared to a headlamp in which a protection circuit is installed, this headlamp provides a more simple structure, thus making it possible to reduce the production cost of the headlamp.

In this headlamp, it would be preferable to emit light by applying a voltage of no more than 4 V to the LED. This is because the use of a nitride semiconductor substrate (the GaN substrate 1) with high electrical conductivity, i.e., low electrical resistance, makes it possible to provide the light-emitting layer with the current needed for light emission at a low applied voltage. The LED can thus output the light needed for a headlamp using a power supply device with limited performance installed in the vehicle. With this headlamp, the LED can emit light using a low voltage, thus limiting the power consumption of the headlamp.

Another headlamp according to the present invention is a headlamp 82 for vehicles equipped with a light source (a group of LEDs formed from multiple LEDs 84) containing one or more light-emitting devices (LEDs 84); and a base member (the pedestal 86 and the rear case 92) for securing the light source to the vehicle. The LED 84 includes: the GaN substrate 1, which is a nitride semiconductor substrate; the n-type AlₓGa₁₋ₓN layer 3 (0<=x<=1), which is an n-type nitride semiconductor layer, on the first main surface side of the nitride semiconductor substrate; the p-type AlₓGa₁₋ₓN layer 5 (0<=x<=1) positioned further away from the nitride semiconductor substrate compared to the n-type AlₓGa₁₋ₓN layer 3; and a light-emitting layer (the MQW (multi-quantum well) 4) positioned between the n-type AlₓGa₁₋ₓN layer 3 and the p-type AlₓGa₁₋ₓN layer 5. In this LED 84 serving as the light-emitting device, the dislocation density of the GaN substrate 1 is no more than 10⁸/cm², the p-type AlₓGa₁₋ₓN layer 5 side is down-mounted, and light is emitted from the second main surface 1a, which is the main surface opposite from the first main surface of the GaN substrate 1.

With this structure, assuming that the GaN substrate 1 of the present invention described above is conductive, reducing the electrical resistance is easy. Thus, in addition to the operations and advantages of a headlamp equipped with the light-emitting device described above, light output from the second main surface 1a can be increased since the dislocation density of the GaN substrate 1 of no more than 10⁸/cm² provides high crystallinity and since the opening ratio is high.

Also, light is emitted from the side surfaces.

Also, since continuity of the index of refraction is maintained, the problems relating to total internal reflection described above do not take place.

Another headlamp according to the present invention is a headlamp 82 for vehicles equipped with a light source (a group of LEDs formed from multiple LEDs 84) containing one or more light-emitting devices (LEDs 84); and a base member (the pedestal 86 and the rear case 92) for securing the light source to the vehicle. The LED 84 includes: a conductive A1N substrate serving as a nitride semiconductor substrate replacing the GaN substrate described above; the n-type AlₓGa₁₋ₓN layer 3 (0<=x<=1), which is an n-type nitride semiconductor layer, on the first main surface side of the A1N substrate; the p-type AlₓGa₁₋ₓN layer 5 (0<=x<=1) positioned further away from the AlN substrate compared to the n-type AlₓGa₁₋ₓN layer 3; and a light-emitting layer (the MQW (multi-quantum well) 4) positioned between the n-type AlₓGa₁₋ₓN layer 3 and the p-type AlₓGa₁₋ₓN layer 5. The head conductivity of the A1N substrate described above is at least 100 W/(m·K), the p-type AlₓGa₁₋ₓN layer 5 side is down-mounted; and light is emitted from the second main surface, which is the main surface opposite from the first main surface of the AlN substrate.

A1N has an extremely high heat conductivity and superior heat dissipation, allowing heat from the p-type AlₓGa₁₋ₓN layer to be transferred to the lead frame and the like so that temperature increases in the light-emitting device can be limited. Heat can also be dissipated from the AlN substrate, contributing to the limiting of temperature increases. It is assumed that impurities have been introduced into this AlN substrate to allow the AlN substrate to have electrical conductivity.

The GaN substrate is n-typed by oxygen doping, the oxygen concentration is in the range of 1E17/cm³ - 2E19/cm³ oxygen atoms, and the thickness of the GaN substrate is 100 microns - 600 microns.

By having the oxygen concentration be at least 1E17/cm³ as described above, the specific resistance of the GaN substrate can be improved, the current introduced from the p-electrode can adequately flow through the GaN substrate, and light can be emitted making adequate use of the area of the light-emitting layer. Also, by making the oxygen concentration no more than 2E19/cm³, the transmittivity for light with a wavelength of 450 nm can be at least 60%, thus improving the transmittivity of the GaN substrate serving as the exit surface and providing good light output. This oxygen concentration range is especially effective in a p-down mounted structure when the thickness of the GaN substrate is 100 - 600 microns.

Also, it would be possible to have this oxygen concentration be in the range of 5E18/cm³ - 2E19/cm³ oxygen atoms, the thickness be in the range of 200 microns - 400 microns, and both sides of the rectangular surface on the second main surface that emits light be no more than 10 mm.

With this structure, light can be emitted from the entire light exit surface, and adequate light output can be obtained.

Furthermore, the oxygen concentration can be in the range of 3E18/cm³ - 5E18/cm³ oxygen atoms, the thickness of the GaN substrate can be in the range of 400 microns - 600 microns, and both sides of the rectangular surface on the second main surface that emits light can be no more than 3 mm. Also, the oxygen concentration can be in the range of 5E18/cm³ - 5E19/cm³ oxygen atoms, the thickness of the GaN substrate can be in the range of 100 microns - 200 microns, and both sides of the rectangular surface on the second main surface that emits light can be no more than 3 mm.

By selecting appropriate oxygen concentration and chip size based on the GaN substrate thickness as described above, a GaN with more suitable performance (uniform light emission over the entire surface, light emission efficiency) can be provided based on the chip size. Also, the optimal conditions in terms of production cost can be selected.

In order to improve crystallinity for the majority of the GaN substrate, it would be possible to use a GaN substrate wherein there is distributed, on average on the first main surface of the GaN substrate at a density of no more than 4E6/cm², dislocation bundles that concentrate unavoidably formed dislocations in discrete string shapes distributed along the thickness axis of the substrate.

With this structure, light-emitting elements with a light output of at least a predetermined value can be produced with a high production yield.

It would also be possible for the dislocation bundles described above to be distributed over the first main surface at no more than 4E2/cm² on average, with both sides of the rectangular surface on the second main surface from which light is emitted being in the range of 200 microns - 400 microns.

In compact light-emitting elements such as those described above, the presence of dislocation bundles leads to unavoidable performance degradation and is directly linked to reduced production yield. By lowering the density of dislocation bundles as described above, the reduction in yield can be kept within a tolerance range that is practical.

It would also be possible, between the GaN substrate and the n-type AlₓGa_{1.x}N layer (0<=x<=1) described above, to form an n-type AlGaN buffer layer in contact with the GaN substrate, an n-type GaN buffer layer in contact with the n-type AlGaN buffer layer, and an n-type AlₓGa₁₋ₓN layer (0<=x<=1) in contact with the n-type GaN buffer layer.

With a hetero-epitaxial layered structure as described above, it would also be possible to form, as described above, an n-type AlGaN buffer layer and an n-type GaN buffer layer between the GaN substrate and the n-type AlₓGa₁₋ₓN layer (0<=x<=1), which is the clad layer for the light-emitting layer.

By forming not only the n-type GaN buffer layer but also the n-type AlGaN buffer layer between the GaN substrate and the clad layer, it is possible to form a hetero-epitaxial layered structure with good crystallinity.

In particular, it would be preferable to use the layered structure above with a GaN substrate having a region with an off angle of no more than 0.10 deg and a region with an off angle of at least 1.0 deg.

With this structure, even if there is warping in the GaN substrate and the off angle varies as described above, the placement of the n-type AlGaN buffer layer in addition to the n-type GaN layer makes it possible to provide a hetero-epitaxial layered structure with superior crystallinity.

It would also be possible to have a structure in which dislocation bundles are distributed on the GaN substrate but distribution bundles are not propagated to the n-type AlGaN buffer layer and the epitaxial layer positioned on the n-type GaN buffer layer that is in contact with the n-type AlGaN buffer layer.

With this structure, a very high production yield is possible even if the GaN substrate has a high dislocation bundle density. More specifically, by arranging the n-type AlGaN buffer layer and the n-type GaN buffer layer in this manner, dislocation bundles can be effectively eliminated in the epitaxial layered structure including the light-emitting layer. The n-type GaN buffer layer and the n-type AlGaN buffer layer stops the dislocation bundles at the GaN substrate or around the layer immediately above it.

It would also be possible to provide a p-type GaN buffer layer in contact with the p-type AlₓGa₁₋ₓN layer (0<=x<=1) and positioned on the down side, and a p-type InGaN contact layer positioned in contact with the p-type GaN buffer layer.

In the structure described above, a p-type InGaN contact layer with superior electrical conductivity can be placed below the p-electrode layer, thus reducing the need to giving priority to work functions and the like in selecting the material for the p-electrode layer. As a result, the material for the p-electrode can be selected by giving priority to reflectivity or the like, for example.

It would be possible for the Mg concentration in the p-type InGaN contact layer to be in the range of 1E18 - 1E21/cm³ Mg atoms.

With this structure, adequate electrical conductivity can be provided and the current introduced through the p-electrode can flow through the entire epitaxial film.

It would be possible for the p-electrode layer to be formed from an Ag layer that is in contact with the p-type InGaN contact layer.

With this structure, light output can be increased by increasing the reflectivity of the mounting section, i.e., the bottom of the light-emitting element, thus reducing the loss of light.

The GaN substrate described above includes plate-shaped inverted crystal domains that extend continuously along the depth axis and on the GaN substrate surface. The plate-shaped inverted crystal domains in the GaN substrate and the plate-shaped inverted crystal domains propagated to the n-type and the p-type nitride semiconductor layers formed on the GaN substrate can be removed from the p-type nitride semiconductor layer side through the n-type nitride semiconductor layer and into the GaN substrate, and, for each remaining p-type nitride semiconductor layer, p-type electrodes can be formed in contact with the p-type nitride semiconductor layer.

With this structure, the light output can be improved since the light extraction surface can be increased.

In the above, an aqueous KOH solution can be used to remove the plate-shaped inverted crystal domains up to a position inside the GaN substrate.

When using an aqueous KOH solution to remove plate-shaped inverted crystal domains, photomasking is not necessary and a non-specular finish can be applied to the second main surface of the nitride semiconductor substrate at the same time. Thus, production costs for the above structure can be reduced by using aqueous KOH solution.

It would also be possible to form: first p-electrodes discretely on the surface of the p-type nitride semiconductor layer and in contact with the p-type nitride semiconductor layer; and a second p-electrode from Ag to fill the gaps between the first p-electrodes and to cover the p-type nitride semiconductor layers and the first p-electrode.

With this structure, the current introduced through the p-electrode can flow adequately through the entire surface, and light output can be improved by increasing reflectivity.

It would also be possible for the covering ratio of the discretely arranged first p-electrodes over the surface of the p-type nitride semiconductor layer to be in the range of 10 - 40%.

With this structure, adequate electrical conductivity can be provided while current can flow through the entire surface. If the covering ratio is less than 10%, current cannot flow thoroughly through the epitaxial layer. If the covering ratio exceeds 40%, the reduction in light extraction efficiency by the discretely arranged p-electrode layers becomes significant.

It would also be possible to place a fluorescent plate away from the nitride semiconductor substrate described above so that it faces the second main surface of the nitride semiconductor substrate.

By placing the fluorescent plate directly above the nitride semiconductor substrate, which forms the p-down mounted light-emitting section, returning light reflected by the back surface of the fluorescent plate is reflected again at the nitride semiconductor surface toward the fluorescent plate side. As a result, light output can be improved.

It would also be possible to form indentations and projections on the surface of the fluorescent plate facing the second main surface of the nitride semiconductor substrate.

With this structure, light extraction efficiency can be improved further.

It would also be possible for the nitride semiconductor substrate described above to serve as a grounding member that grounds transient voltages and static discharge.

In order to protect the light-emitting element from high voltages from transient voltages and static discharge applied between the nitride semiconductor substrate and the down-mounted p-type AlₓGa₁₋ₓN layer side, the nitride semiconductor substrate, which has a high electrical conductivity, can be used as a grounding member that grounds high voltages. As a result, there is no need to provide a protection circuit such as a power shunting circuit containing a zener diode to handle transient voltages and static discharge. Transient voltages and static discharge are major factors in circuit malfunctions in group III nitride semiconductors. If the electrical conductivity of the nitride semiconductor substrate is high as described above, the substrate can be used as a grounding member to significantly reduce production steps and production costs.

It would also be possible to have the light-emitting element emit light when a voltage of no more than 4 V is applied. By using a nitride semiconductor substrate with a high electrical conductivity, i.e., low electrical resistance, light can be emitted by applying an adequate current with a low potential to the light-emitting element to emit light. As a result, fewer batteries need to be installed, thus making an illumination device equipped with the light-emitting element more compact, lighter, and less costly. Also, power consumption is limited.

It would also be possible for the thickness of the nitride semiconductor substrate to be at least 50 microns.

With this structure, when electrons are injected through a point-shaped or small-area n-electrode, the electrons spread inward from the surface of the GaN substrate or the n-type nitride semiconductor substrate. As a result, it would be preferable for the GaN substrate or the n-type nitride semiconductor to be thicker. If the n-electrode has a small area when the thickness of the substrate is less than 50 microns, the electrons cannot spread adequately when they reach the light-emitting layer of the multi-quantum well, resulting in sections of the light-emitting layer that do not emit light or from which light emission is not adequate. By setting the thickness of the substrate to be at least 50 microns, current can spread adequately in the substrate even when the area of the n-electrode is small since the electrical resistance is low. This makes it possible for the light-emitting section of the light-emitting layer to be adequately large. It would be more preferable for the thickness to be at least 75 microns. However, if the substrate is too thick, the absorption by the substrate becomes non-negligible, so it would be preferable for the thickness to be no more than 500 microns.

It would also be possible for an electrode to be formed on the second main surface of the nitride semiconductor substrate with an opening ratio of at least 50%.

With this structure, the light emission efficiency from the second main surface can be increased. The amount of light absorbed by the n-electrode decreases for higher opening ratios, so light output can be increased. Thus, it would be more preferable for the opening ratio to be at least 75%, and even more preferably, at least 90%.

It would also be possible for the contact area between an electrode disposed on the nitride semiconductor substrate and the nitride semiconductor substrate to be at least 0.55 mm².

With this structure, linear current-light output characteristics can be provided up to approximately 70 A with an 8 mm□ semiconductor chip without being affected by electrode heat generation.

It would also be possible for the bonding wire electrically connecting the electrode and the lead frame to have a cross-section area of at least 0.002 mm².

With this structure, the element can operate up to a current of 2 A without being affected by heat generated by the wire.

It would also be possible for the bonding wire electrically connecting the electrode and the lead frame to have a cross-section area of at least 0.07 mm².

With this structure, the element can operate up to a current of 70 A without being affected by heat generated by the wire.

It would also be possible for electrodes to be positioned separately at at least two corners of the nitride semiconductor substrate, the total contact area between the electrodes and the nitride semiconductor substrate to be at least 0.055 mm², and the total cross-section area of the bonding wires electrically connecting the lead frame to the electrodes at the corners to be 0.002 mm².

With this structure, there are almost no sections that will obstruct light from the semiconductor chip.

It would also be possible for the total cross-section area of the bonding wire electrically connecting the lead frame to the electrodes at the corners to be at least 0.07 mm².

With this structure, there are almost no sections that will obstruct light extraction, thus increasing light output efficiency.

It would also be possible for the area of the second main surface from which light is emitted to be at least 0.25 mm².

With this structure, the range of conventional illumination devices that can be replaced can be increased by arranging a predetermined number of the light-emitting elements described above. If the area of the section that emits light is less than 0.25 mm², the number of light-emitting elements to be used becomes too high, preventing the replacement of conventional illumination devices. The light-emitting section in the embodiment of the present invention described above is the nitride semiconductor substrate, and it would be preferable for the size to be as large as possible while allowing adequately wide current flow. This means that the light-emission area can be greater if the electrical resistance is lower, e.g., if the specific resistance of the nitride semiconductor substrate is 0.01 Ω cm, the size can be approximately 8 mm × 8 mm as in the invention sample F.

It would also be possible for the section of the second main surface of the nitride semiconductor substrate that emits light to have a size of at least 1 mm × 1 mm. It would also be possible for the section of the second main surface of the nitride semiconductor substrate that emits light to have a size of at least 3 mm × 3 mm. Furthermore, it would also be possible for the section of the second main surface of the nitride semiconductor substrate that emits light to have a size of at least 5 mm × 5 mm.

By increasing the area of the light exit surface as described above, the number of light-emitting elements to be mounted in an illumination device can be reduced, thus reducing the number of processing steps, reducing the number of parts, limiting power consumption, and the like. To be explicit a size of "at least 1 mm × 1 mm" includes a size of 1 mm × 1 mm.

It would also be possible for the heat resistance of the light-emitting element to be no more than 30 deg C/W, including light-emitting elements formed on an AlN substrate.

When the temperature of a light-emitting element increases, light-emission efficiency decreases, and excessive temperature increases can lead to damage to the light-emitting element. As a result, temperature and heat resistance are important design factors in light-emitting elements. Conventionally, heat resistances of approximately 60 deg C/W have been used (the Japanese Laid-Open Patent Publication Number 2003-8083 described above). However, by designing the element as described above so that the heat resistance is no more than 30 deg C/W, significant reduction in light-emission efficiency and damage to the light-emitting element can be prevent even when high electrical power is applied to the light-emitting element. The possibility of halving heat resistance in this manner is only possible because of the use of a GaN substrate having a low specific resistance.

It would also be possible, in the light-emitting element described above, for the temperature of the section that experiences the greatest temperature increase during continuous light emission to be no more than 150 deg C.

With this structure, the temperature of the section at which the temperature increase is greatest, i.e., the light-emitting layer, is no more than 150 deg C, making it possible to provide adequately high light-emission efficiency. Furthermore, compared to conventional light-emitting elements, the lifespan can be increased significantly.

It would also be possible for the thickness of the n-type nitride semiconductor layer to be no more than 3 microns.

With this n-type semiconductor layer, epitaxial growth is performed on the nitride semiconductor substrate. If the thickness is too great, the time required for film formation increases and raw material costs increase as well. By having the thickness of the n-type nitride semiconductor layer be no more than 3 microns, a large cost reduction can be provided. It would be more preferable for the thickness to be no more than 2 microns.

It would also be possible to apply a non-specular finish to the section of the second main surface of the nitride semiconductor substrate that is not covered by an electrode.

With this structure, it is possible to prevent reduced efficiency caused by total internal reflection at the second main surface, i.e., the exit surface of light from the light-emitting layer, resulting in the light being trapped in the substrate. Of course, it would also be possible to apply a non-specular finish to the surface on the layered structure side.

It would also be possible for the surface with a non-specular finish as described above to be a surface with a non-specular finish applied using a potassium hydroxide (KOH) aqueous solution, a sodium hydroxide (NaOH) aqueous solution, an ammonia (NH₃) aqueous solution, or some other alkali aqueous solution.

With this type of non-specular finishing, a surface with large indentations and projections formed only on the N surface of a GaN substrate can be obtained efficiently. The Ga surface side is not etched.

It would also be possible for the surface with a non-specular finish as described above to be a surface with a non-specular finish applied using at least one of a sulfuric acid (H₂SO₄) aqueous solution, a hydrochloric acid (HCl) aqueous solution, a phosphoric acid (H₂PO₄) aqueous solution, a hydrofluoric acid (HF) aqueous solution, or some other type of acid aqueous solution.

It would also be possible for the surface on which a non-specular finish was applied to be a surface on which a non-specular finish was applied using RIE. As a result, a non-specular surface with superior precision for area dimensions can be provided through a dry process. Furthermore, predetermined indentation and projection intervals can be obtained by combining photolithography and dry etching with RIE or wet etching with an alkali aqueous solution.

It would also be possible to form an electrode disposed on the p-type nitride semiconductor layer from a material with a reflectivity of at least 0.5.

With this structure, light absorption on the mounting surface side can be prevented and the amount of light emitted can be increased by reflecting light toward the second main surface of the substrate. Higher reflectivity is better, and it would be preferable for the reflectivity to be at least 0.7.

It would also be possible to have fluorescent body disposed so that it covers the second main surface of the nitride semiconductor substrate. Also, the light-emitting device described above can include a fluorescent plate disposed away from the nitride semiconductor substrate and facing the second main surface of the nitride semiconductor substrate. Furthermore, the surface of the fluorescent plate that faces the second main surface of the nitride semiconductor substrate may be processed to form indentations and projections. Also, it would be possible to include an impurity and/or a defect that emits fluorescence in the nitride semiconductor substrate.

With this structure, a white LED can be formed.

It would also be possible for the light-emitting element of the present invention to include at least two light-emitting elements described above, and these light-emitting elements can be connected in series.

With this structure, a high-voltage power supply can be used to provide an illumination part in which multiple high-efficiency light-emitting elements are mounted in a lead frame or the like. For example, since an automobile battery is approximately 12 V, light can be emitted by connecting in series 4 or more stages of light-emitting elements according to the present invention.

It would also be possible for another light-emitting element according to the present invention to include at least two of the light-emitting elements described above, with these light-emitting elements being connected in parallel.

With this structure, it is possible to provide an illumination part formed from the high-efficiency light-emitting elements described above using a high-current power supply.

It would also be possible to have a structure that includes light-emitting elements and a power supply circuit for lighting these light-emitting elements, where, in the power supply circuit, there is a series connection of at least two parallel sections, in which at least two light-emitting elements are connected in parallel.

With this structure, it is possible to make the capacity of the illumination parts consistent with the power supply capacity while meeting the light-emission conditions for the individual light-emitting elements. In the power supply circuit described above, if the capacity of the illumination device is to be made variable, a series/parallel selector can be provided so that the connections to the light-emitting elements can be selected by the series/parallel selector.

The above description presented embodiments and examples of the present invention but the above embodiments and examples of the present invention are simply examples and the scope of the present invention is not restricted to these embodiments of the invention. The scope of the invention is indicated by the scope of the claims and also encompasses the scope of equivalences with the claims.

A light-emitting device used in headlamps according to the present invention uses a high-conductivity nitride semiconductor substrate and a p-down mounted structure. As a result: (1) superior heat dissipation is provided and high light output is possible without requiring complex electrode structures; (2) superior conductivity is provided, there is no need to provide a protection circuit to protect the light-emitting element from transient voltages and static discharge, and superior large-area light emission and a high electrostatic withstand voltage is provided; (3) since there are no discontinuities from high to low indices of refraction going from the light-emitting layer to the substrate, total internal reflection tends not to occur going from the light-emitting layer to the exit surface, thus preventing reduced efficiency and resin degradation at the side surfaces caused by total internal reflection; (4) light is emitted with a low voltage so there is no need for a high-capacity power supply, thus making the device suited for use in illumination devices for automobiles; and (5) since a simple structure is used, production is easy and inexpensive, and the device is easy to maintain. As a result, it is expected that the present invention will be used in a wide range of illumination products, including illumination devices for automobiles.

## Claims

1. An automotive headlamp comprising:
a light source including one or a plurality of light-emitting devices; and
a base member for securing said light source to an automobile;
wherein:
said light-emitting device includes: a nitride semiconductor substrate; an n-type nitride semiconductor layer on a first main surface side of said nitride semiconductor substrate; a p-type nitride semiconductor layer positioned further away from said nitride semiconductor substrate compared to said n-type nitride semiconductor layer; and a light-emitting layer positioned between said n-type nitride semiconductor layer and said p-type nitride semiconductor layer;
said nitride semiconductor substrate has a specific resistance of no more than 0.5 Ω·cm; and
said p-type nitride semiconductor layer side is down-mounted and light is emitted from a second main surface, which is a main surface of said nitride semiconductor substrate opposite from said first main surface.

2. A headlamp as in claim 1 wherein said nitride semiconductor substrate is formed from GaN or AlₓGa₁₋ₓN (0<x<=1).

3. A headlamp as in claim 1 or claim 2 wherein said nitride semiconductor substrate has a dislocation density of no more than 1E8/cm³.

4. A headlamp as in any one of claim 1 through claim 3 wherein said nitride semiconductor substrate has a heat conductivity of at least 100 W/(m·K).

5. A headlamp as in any one of claim 1 through claim 4 wherein output from one of said light-emitting devices is at least 300 lumens (1m).

6. A headlamp as in any one of claim 1 through claim 5 wherein output from one of said light-emitting devices is at least 1000 lumens (1m).

7. A headlamp as in any one of claim 1 through claim 6 wherein a section of said second main surface of said nitride semiconductor substrate that emits light has a size of at least 1 mm × 1 mm.

8. A headlamp as in claim 7 wherein:
said nitride semiconductor substrate is n-typed through oxygen doping;
oxygen concentration in said nitride semiconductor substrate is at least 2E18/cm³ and no more than 2E19/cm³; and
said nitride semiconductor substrate has a thickness of at least 200 microns and no more than 400 microns.

9. A headlamp as in any one of claim 1 through claim 6 wherein a section of said second main surface of said nitride semiconductor substrate that emits light has a size of at least 2 mm × 2 mm.

10. A headlamp as in claim 9 wherein:
said nitride semiconductor substrate is n-typed through oxygen doping;
oxygen concentration in said nitride semiconductor substrate is at least 3E18/cm³ and no more than 2E19/cm³; and
said nitride semiconductor substrate has a thickness of at least 200 microns and no more than 400 microns.

11. A headlamp as in any one of claim 1 through claim 10 wherein said light-emitting device has an electrostatic withstand voltage of at least 3000 V.

12. A headlamp as in any one of claim 1 through claim 11 wherein no special protection circuit is provided to protect said light-emitting device from transient voltages and static discharge applied between said nitride semiconductor substrate and said down-mounted p-type nitride semiconductor layer.

13. A headlamp as in claim 12 wherein no power shunting circuit containing a zener diode is provided to handle transient voltages and static discharge.

14. A headlamp as in any one of claim 1 through claim 13 wherein said light-emitting device emits light when a voltage of no more than 4 V is applied.

15. A headlamp as in any one of claim 1 through claim 14 wherein:
said light-emitting device includes an electrode disposed on said second main surface of said nitride semiconductor substrate; and
a non-specular finish is applied to sections of said second main surface of said nitride semiconductor substrate not covered by said electrode.

16. A headlamp as in claim 15 wherein, in said second main surface of said nitride semiconductor substrate, a section on which said non-specular finish is applied is a surface on which a non-specular finish is applied using a potassium hydroxide (KOH) aqueous solution, a sodium hydroxide (NaOH) aqueous solution, an ammonia (NH₃) aqueous solution, or some other alkali aqueous solution.

17. A headlamp as in claim 15 wherein, in said second main surface of said nitride semiconductor substrate, a section on which said non-specular finish is applied is a surface on which a non-specular finish is applied using at least one of a list consisting of: a sulfuric acid (H₂SO₄) aqueous solution, a hydrochloric acid (HCl) aqueous solution, a phosphoric acid (H₂PO₄) aqueous solution, a hydrofluoric acid (HF) aqueous solution, or some other type of acid aqueous solution.

18. A headlamp as in claim 15 wherein, in said second main surface of said nitride semiconductor substrate, a section on which said non-specular finish is applied is a surface on which a non-specular finish is applied using reactive ion etching (RIE).

19. A headlamp as in any one of claim 1 through claim 18 wherein:
said light-emitting device includes a p-electrode disposed to be in contact with said p-type nitride semiconductor layer; and
said electrode is formed from a material with a reflectivity of at least 0.5.

20. A headlamp as in any one of claim 1 through claim 19 wherein said light-emitting device includes a fluorescent body disposed to cover said second main surface of said nitride semiconductor substrate.

21. A headlamp as in any one of claim 1 through claim 19 wherein said light-emitting device includes a fluorescent plate disposed away from said nitride semiconductor substrate and facing said second main surface of said nitride semiconductor substrate.

22. A headlamp as in claim 21 wherein a surface of said fluorescent plate facing said second main surface of said nitride semiconductor substrate is formed with projections and indentations.

23. A headlamp as in any one of claim 1 through claim 19 wherein said nitride semiconductor substrate contains an impurity and/or a defect.

24. A headlamp as in any one of claim 1 through claim 23 wherein:
said light source includes a plurality of light-emitting devices; and
said light-emitting devices are connected either in series or in parallel.

25. A headlamp as in any one of claim 1 through claim 24 wherein:
said light source includes a plurality of light-emitting devices;
a power supply circuit is provided to allow said light source to emit light; and
in said power supply circuit, at least two parallel sections are connected in series, each parallel section being formed from at least two of said light-emitting device connected in parallel.
